# EUROPEAN PATENT APPLICATION

(11) **EP 4 716 397 A1**
(43) Date of publication of application: **25.03.2026**
(21) Application number: 25200656.4
(22) Date of filing: 05.09.2025
(51) Int. Cl.: H10B 12/00, H10D 30/67

(54) **SEMICONDUCTOR MEMORY DEVICE**

(30) Priority: 20.09.2024 KR 20240127541
(71) Applicant: Samsung Electronics Co., Ltd., Suwon-si, Gyeonggi-do 16677 (KR)
(72) Inventor: BAE, Byeongju, 16677 Suwon-si (KR); CHOI, Dasom, 16677 Suwon-si (KR)
(74) Representative: Marks & Clerk LLP

(57) **Abstract**

A semiconductor memory device includes a stack structure including word lines and interlayer insulating patterns alternately stacked on a semiconductor substrate, the word lines extending in a first direction parallel to a top surface of the semiconductor substrate; channel patterns intersecting the word lines and having a long axis in a second direction parallel to the top surface of the semiconductor substrate; a lower separation insulating layer on the semiconductor substrate at a first side of the stack structure; and bit lines spaced apart from each other on the lower separation insulating layer in the first direction, each of the bit lines connected to first end portions of the channel patterns which are spaced apart from each other in the third direction. The lower separation insulating layer is on a first side surface of a lowermost channel pattern of the channel patterns.

## Description

### BACKGROUND

The present disclosure relates to a semiconductor memory device, and more particularly, to a three-dimensional semiconductor memory device with more improved reliability and integration.

An electronic system that uses data storage may require a semiconductor device capable of storing a large amount of data. Accordingly, research on methods for increasing data storage capacity of semiconductor devices is being conducted. For example, a semiconductor device including memory cells three-dimensionally arranged, instead of arranging the memory cells two-dimensionally, is being proposed as one of the methods for increasing the data storage capacity of the semiconductor device.

### SUMMARY

Some embodiments of the disclosure provide a semiconductor memory device with improved reliability and integration. As an example, the semiconductor memory device may be a direct random access memory device (DRAM).

The object of the disclosure is not limited to the goal mentioned above, and other technical goals that are not mentioned may be clearly understood from the description below by those skilled in the art.

According to some embodiments of the present disclosure, a semiconductor memory device includes a stack structure including word lines and interlayer insulating patterns alternately stacked on a semiconductor substrate, the word lines extending in a first direction parallel to a top surface of the semiconductor substrate, channel patterns intersecting the word lines and having a long axis in a second direction parallel to the top surface of the semiconductor substrate, the channel patterns spaced apart from each other in the first direction and in a third direction perpendicular to the top surface of the semiconductor substrate, a lower separation insulating layer on the semiconductor substrate at a first side of the stack structure, and bit lines spaced apart from each other on the lower separation insulating layer in the first direction, each of the bit lines connected to first end portions of the channel patterns which are spaced apart from each other in the third direction, wherein the lower separation insulating layer is on a first side surface of a lowermost channel pattern of the channel patterns.

According to some embodiments of the present disclosure, a semiconductor memory device includes a stack structure including word lines and interlayer insulating patterns alternately stacked on a semiconductor substrate, the word lines extending in a first direction parallel to a top surface of the semiconductor substrate, channel patterns intersecting the word lines and having a long axis in a second direction parallel to the top surface of the semiconductor substrate, the channel patterns spaced apart from each other on the semiconductor substrate in the first direction and in a third direction perpendicular to the top surface of the semiconductor substrate, a lower separation insulating layer on the semiconductor substrate on a first side of the stack structure, bit lines spaced apart from each other on the lower separation insulating layer in the first direction, each of the bit lines connected to first end portions of the channel patterns which are spaced apart from each other in the third direction, and upper separation insulating patterns between the bit lines, respectively, and adjacent to each other in the first direction, wherein the lower separation insulating layer includes an insulating material having a lower dielectric constant than that of the upper separation insulating patterns.

According to some embodiments of the present disclosure, a semiconductor memory device includes a stack structure including word lines and interlayer insulating patterns alternately stacked on a semiconductor substrate, the word lines extending in a first direction parallel to a top surface of the semiconductor substrate; channel patterns intersecting the word lines and having a long axis in a second direction parallel to the top surface of the semiconductor substrate, the channel patterns spaced apart from each other on the semiconductor substrate in the first direction and in a third direction perpendicular to the top surface of the semiconductor substrate; a lower separation insulating layer on the semiconductor substrate on a first side of the stack structure; bit lines spaced apart from each other in the first direction on the lower separation insulating layer, each of the bit lines connected to first end portions of the channel patterns which are spaced apart from each other in the third direction; upper separation insulating patterns between the bit lines, respectively, and adjacent to each other in the first direction; first separation insulating patterns between the first end portions of the channel patterns, respectively, and spaced apart from each other in the first direction; second separation insulating patterns between second end portions opposite to the first end portions of the channel patterns, and spaced apart from each other in the first direction; and data storage elements between the interlayer insulating patterns, respectively, adjacent to each other in the third direction, and connected to the second end portions of the channel patterns.

At least some of the above and other features of the invention are set out in the claims.

Specific details of other embodiments are included in the detailed description and the brief description of the figures.

### BRIEF DESCRIPTION OF THE FIGURES

The inventive concept will become more apparent by describing in detail embodiments thereof with reference to the attached drawings and accompanying detailed description.
FIG. 1A is a plan view illustrating a semiconductor memory device according to embodiments of the inventive concept;
FIG. 1B is a cross-sectional view taken along line A-A' and line B-B' of FIG. 1A to illustrate a cell array structure of a semiconductor memory device according to embodiments of the inventive concept;
FIG. 1C is a cross-sectional view taken along line C-C' and line D-D' of FIG. 1A to illustrate a cell array structure of a semiconductor memory device according to embodiments of the inventive concept;
FIG. 1D is an enlarged diagram of portion 'P1' of FIG. 1B;
FIG. 1E is an enlarged diagram of portion 'P2' of FIG. 1C;
FIG. 2A is a cross-sectional view taken along line A-A' and line B-B' of FIG. 1A to illustrate a cell array structure of a semiconductor memory device according to embodiments of the inventive concept;
FIG. 2B is a cross-sectional view taken along line C-C' and line D-D' of FIG. 1A to illustrate a cell array structure of a semiconductor memory device according to embodiments of the inventive concept;
FIG. 2C is an enlarged views of portion 'P1' of FIG. 2A;
FIG. 2D is an enlarged views of portion 'P2' of FIG. 2B;
FIGS. 3A, 4A, 5A, 6A, 7A, 8A, 9A, 10A, 11A, 12A, 13A, 14A, 15A, 16A, and 17A are plan views illustrating a method for manufacturing a semiconductor memory device according to embodiments of the inventive concept;
FIGS. 3B, 4B, 5B, 6B, 7B, 8B, 9B, 10B, 11B, 12B, 13B, 14B, 15B, 16B, and 17B are cross-sectional views taken along line A-A' and line B-B' of FIGS. 1A, 2A, 3A, 4A, 5A, 6A, 7A, 8A, 9A, 10A, 11A, 12A, 13A, 14A, 15A, 16A, and 17A to illustrate a method for manufacturing a semiconductor memory device according to embodiments of the inventive concept;
FIGS. 3C, 4C, 5C, 6C, 7C, 8C, 9C, 10C, 11C, 12C, 13C, 14C, 15C, 16C, and 17C are cross-sectional views taken along line C-C' and line D-D' of FIGS. 1A 2A, 3A, 4A, 5A, 6A, 7A, 8A, 9A, 10A, 11A, 12A, 13A, 14A, 15A, 16A, and 17A to illustrate a method for manufacturing a semiconductor memory device according to embodiments of the inventive concept; and
FIG. 18 is a perspective view illustrating a semiconductor memory device according to embodiments of the inventive concept.

### DETAILED DESCRIPTION

Hereinafter, a semiconductor device and a method for manufacturing the same according to embodiments of the inventive concept will be described in detail with reference to the drawings. In the drawings, like reference numerals denote like elements, and repeated descriptions thereof are omitted. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

As used herein, the singular forms "a", "an", and "the" are intended to include the plural forms as well, unless the context clearly indicates otherwise. Additionally, the description may be specific to a portion of the semiconductor memory device and the described structure may be repeated in other portions of the semiconductor memory device. For example, the described structure may be an individual element of an array of elements forming the semiconductor memory device. Accordingly, where the structure of a single element of a plurality of elements has been described, this structure may equally apply to other elements of the plurality of elements.

As used herein, the terms "substantially," "about," and similar terms are used as terms of approximation and not as terms of degree, and are intended to account for the inherent variations in measured or calculated values that would be recognized by those of ordinary skill in the art. Parameters and/or ends of ranges that are quoted as being "about" a certain value (e.g. "about X") may be considered equal to that value (e.g. "equal to X"). Nevertheless, any values quoted herein may include variations of that value within commonly accepted errors, margins and/or tolerances (e.g. manufacturing tolerances). For instance, any values quoted herein may also cover variations within ±5% or ±10%.

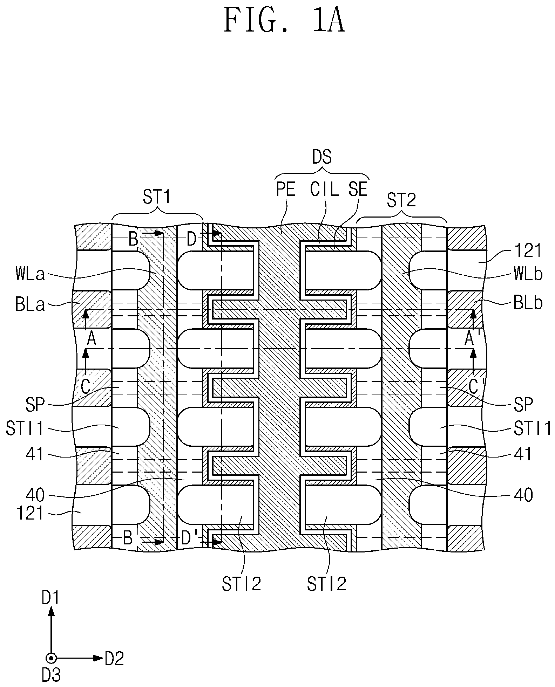

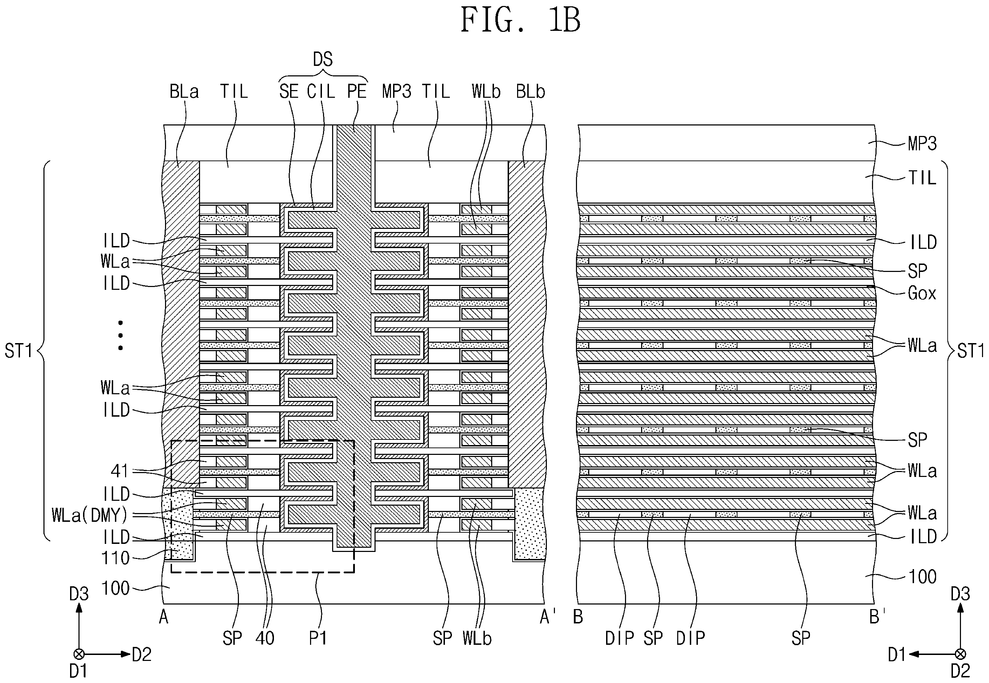

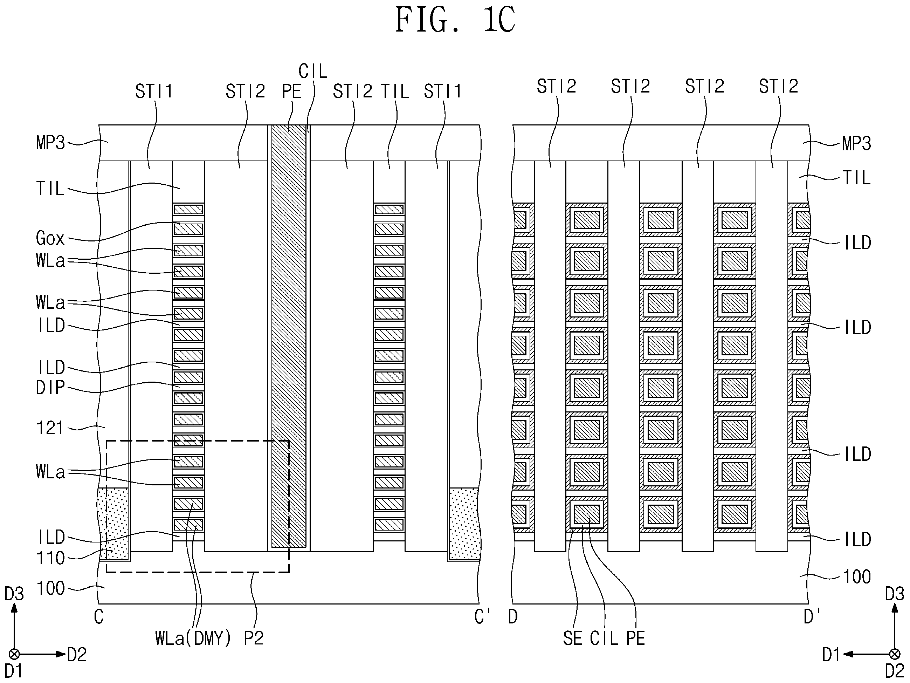

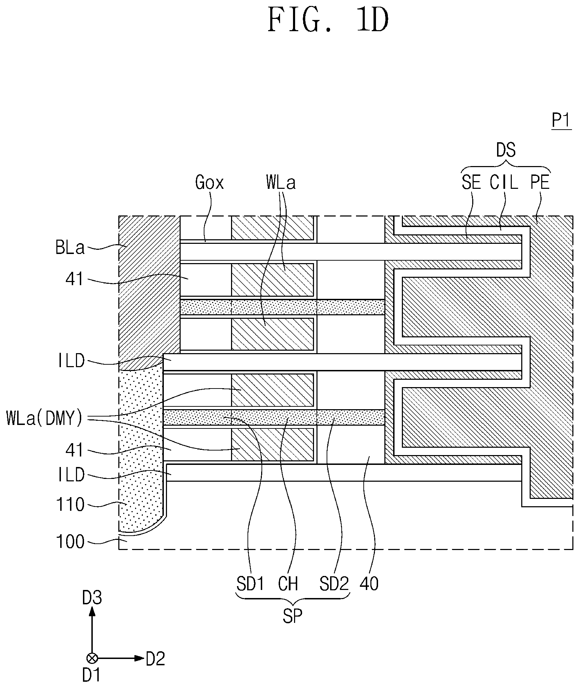

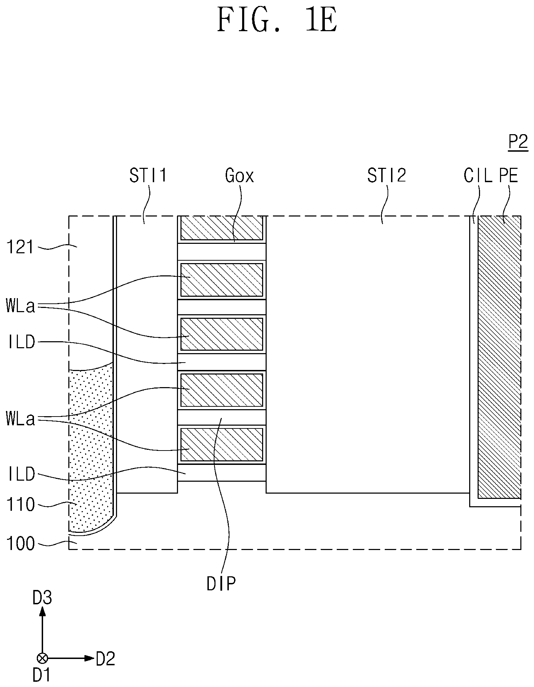

FIG. 1A is a plan view illustrating a semiconductor memory device according to embodiments of the inventive concept. FIG. 1B is a cross-sectional view taken along line A-A' and line B-B' of FIG. 1A to illustrate a cell array structure of a semiconductor memory device according to embodiments of the inventive concept. FIG. 1C is a cross-sectional view taken along line C-C' and line D-D' of FIG. 1A to illustrate a cell array structure of a semiconductor memory device according to embodiments of the inventive concept. FIG. 1D is an enlarged diagram of portion 'P1' of FIG. 1B. FIG. 1E is an enlarged diagram of portion 'P2' of FIG. 1C.

Referring to FIGS. 1A, 1B, and 1C, the semiconductor memory device may include first and second stack structures ST1 and ST2 disposed on a semiconductor substrate 100.

The semiconductor substrate 100 may include a semiconductor material (for example, a silicon wafer), an insulating material (for example, glass), or one of a semiconductor or conductor at least partially covered by the insulating material.

A first stack structure ST1 may extend along a first direction D1 parallel to a top surface of the semiconductor substrate 100. The first stack structure ST1 may be located on the top surface of the semiconductor substrate 100. The first stack structure ST1 may include first word lines WLa stacked in a third direction D3 perpendicular to the top surface of the semiconductor substrate 100 by interposing interlayer insulating patterns ILD. A second stack structure ST2 may be spaced apart from the first stack structure ST1 in a second direction D2 intersecting the first direction D1 and being parallel to the top surface of the semiconductor substrate 100. The second stack structure ST2 may be located on the top surface of the semiconductor substrate 100. The second stack structure ST2 may extend along the first direction D1. The second stack structure ST2 may include second word lines WLb stacked on the semiconductor substrate 100 along the third direction D3 by interposing the interlayer insulating patterns ILD. Each of the first and second stack structures ST1 and ST2 may include an upper insulating layer TIL covering uppermost first and second word lines WLa and WLb. The first and second directions D1 and D2 may be considered horizontal directions and the third direction D3 may be considered a vertical direction. The third direction D3 may define a height direction. Features described as "above" other features may be located further along the third direction D3 than the other features. A "top surface" of an element may be a surface that is located furthest along the third direction. It will be appreciated that the directions and positions defined herein are defined relative to the structure of the semiconductor memory device, and therefore need not limit the orientation of the semiconductor memory device in use.

In some embodiments, each of the first and second word lines WLa and WLb may have a double gate structure in which the first or second word line WLa or WLb is provided on an upper surface and a lower surface of a channel pattern SP. In other embodiments, each of the first and second word lines WLa and WLb may have a structure (that is, a gate-all-around structure) in which the first or second word line WLa or WLb completely surrounds the channel pattern SP in a cross-sectional view (e.g. in a cross-sectional view taken along the first direction D1 and third direction D3).

Each of the first and second word lines WLa and WLb may include a line portion, extending in the first direction D1, parallel to the top surface of the semiconductor substrate 100, and gate electrode portions protruding from the line portion in the second direction D2. Here, the line portion may be disposed between first and second separation insulating patterns STI1 and STI2. In addition, in the second direction D2, a width of the gate electrode portion may be greater than a width of the line portion. A pair of first and second word lines WLa and WLb may be mirrored to each other on the basis of a plate electrode PE (e.g. based on an axis of symmetry passing through the plate electrode PE, for instance, along the first direction D1), when viewed in a plan view.

The first and second word lines WLa and WLb may be any one among a doped semiconductor material (for example, doped silicon, doped germanium, or the like), conductive metal nitride (for example, titanium nitride, tantalum nitride, or the like), metal (for example, tungsten, titanium, tantalum, or the like), and a metal-semiconductor compound (for example, tungsten silicide, cobalt silicide, titanium silicide, or the like).

Lowermost first and second word lines WLa and WLb provided on and under a lowermost channel pattern SP may be used as dummy word lines DMY. In this context, the term "lowermost" may refer to one or more items out of a set of items that is/are located closest to the semiconductor substrate 100 (e.g. located least far along the third direction D3 out of the set of items).

The channel patterns SP may be stacked in the third direction D3, and may be spaced apart from each other in the first direction D1 and the second direction D2. That is, the channel patterns SP may be three-dimensionally arranged on the semiconductor substrate 100. Each of the channel patterns SP may have a shape of a bar crossing the first or second word line WLa or WLb, and having a long axis in the second direction D2. That is, the channel patterns SP may be extended in the second direction D2 (e.g. the longest axis of the channel patterns SP may be in the second direction D2). When the first and second word lines WLa and WLb have the double gate structure, dummy insulating patterns DIP may be disposed between the channel patterns SP arranged along the first direction D1, and between a pair of gates (e.g. between each pair of gates).

The channel patterns SP may include silicon (Si), germanium (Ge) and/or silicon-germanium (SiGe). For example, the channel patterns SP may be composed of single-crystalline silicon. According to some embodiments, the channel patterns SP may have a greater bandgap energy than silicon. For example, the channel patterns SP may have a bandgap energy of about 1.5 eV to about 5.6 eV. The bandgap energy may be measured at room temperature (e.g. 300-302 K) and ambient pressure (e.g. 101.3 kPa). For example, when the channel patterns SP have a bandgap energy of about 2.0 eV to about 4.0 eV, the channel pattern SP may have an optimal channel performance. For example, the channel patterns SP may include an oxide semiconductor, and the oxide semiconductor may include, for example, ZnₓSn_{y}O(ZTO), InₓZn_{y}O(IZO), ZnₓO, InₓGa_{y}Zn_{z}O(IGZO), InₓGa_{y}Si_{z}O(IGSO), InₓW_{y}O(IWO), InₓO, SnₓO, TiₓO, ZnₓON_{z}, MgₓZn_{y}O, ZrₓIn_{y}Zn_{z}O, HfₓIn_{y}Zn_{z}O, SnₓIn_{y}Zn_{z}O, AlₓSn_{y}In_{z}ZnₐO, SiₓIn_{y}Zn_{z}O, AlₓZn_{y}Sn_{z}O, GaₓZn_{y}Sn_{z}O, ZrₓZn_{y}Sn_{z}O, or a combination thereof.

A gate insulating layer Gox may be interposed between the channel patterns SP and the first and second word lines WLa and WLb. The gate insulating layer Gox may be on and at least partially cover an upper surface, a lower surface and one sidewall (e.g. in the second direction D2) of each of the first and second word lines WLa and WLb with a uniform thickness. The gate insulating layers Gox may include one single layer selected from a high dielectric layer (e.g. a high-k dielectric layer), a silicon oxide layer, a silicon nitride layer and a silicon oxynitride layer, or a combination thereof. For example, the high dielectric layer may include at least one of hafnium oxide, hafnium silicon oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, and/or lead zinc niobate. A high dielectric layer (e.g. a high-k dielectric layer) may be a layer having a higher dielectric constant than that of silicon oxide.

Referring to FIG. 1D, each of the channel patterns SP may include first and second dopant regions SD1 and SD2 spaced apart from each other, and a channel region CH between the first and second dopant regions SD1 and SD2. The first and second dopant regions SD1 and SD2 of each channel pattern SP may include a first conductive dopant (for example, phosphorous, or boron). The first and second dopant regions SD1 and SD2 may be source/drain regions.

First spacer insulating patterns 41 may be disposed between word lines WL and bit lines BL, and may be respectively disposed between the interlayer insulating patterns ILD vertically (D3 direction) adjacent thereto. The first spacer insulating patterns 41 may be disposed on an upper surface and a lower surface of the first dopant region SD1, which are first end portions of the channel pattern SP.

Second spacer insulating patterns 40 may be disposed between the word lines WL and data storage elements DS, and may be respectively disposed between the interlayer insulating patterns ILD vertically (D3 direction) adjacent thereto. The second spacer insulating patterns 40 may be disposed on an upper surface and a lower surface, of the second dopant region SD2, which are second end portions of the channel pattern SP. In the second direction D2, a width of the second spacer insulating patterns 40 may be greater than a width of the first spacer insulating patterns 41.

A lower separation insulating layer 110 may be disposed on one side (e.g. a lower/bottom side) of the first and second stack structures ST1 and ST2 on the semiconductor substrate 100. The lower separation insulating layer 110 may extend parallel to the first and second stack structures ST1 and ST2 in the first direction D1.

The lower separation insulating layer 110 may be on and at least partially cover a first side surface of at least one channel pattern SP (e.g. at least one lowermost channel pattern) from the top surface of the semiconductor substrate 100. The lower separation insulating layer 110 may have a thickness range of about 1 Å to about 1000 Å.

The lower separation insulating layer 110 may include an insulating material different from the interlayer insulating patterns ILD. The lower separation insulating layer 110 may be formed of an insulating material having a lower dielectric constant than a silicon oxide layer. The lower separation insulating layer 110 may be composed of an insulating material including carbon. A content of carbon may be about 5% to about 60% in the lower separation insulating layer 110. For example, the lower separation insulating layer 110 may be formed of a fluorine-doped oxide (FSG) layer, a carbon-doped oxide layer, a silicon oxide layer, hydrogen silsesquioxane (HSQ; SiO:H), methyl silsesquioxane (MSQ; SiO:CH3), and/or a-SiOC (SiOC:H), or the like.

More specifically, referring to FIGS. 1D and 1E, the lower separation insulating layer 110 may have a rounded upper surface and a round bottom surface. The bottom surface may be convex (e.g. may be rounded outwards, e.g. towards the semiconductor substrate 100). The upper surface may be concave (e.g. may be rounded inwards, e.g. towards the semiconductor substrate 100). The bottom surface of the lower separation insulating layer 110 may be located at a lower level (D3 direction) than the top surface of the semiconductor substrate 100. The bottom surface of the lower separation insulating layer 110 may be located at a lower level (D3 direction) than a lowermost interlayer insulating pattern among the interlayer insulating patterns ILD. The lowermost interlayer insulating pattern may contact the semiconductor substrate 100.

The lower separation insulating layer 110 may be on and at least partially cover sidewalls of at least two interlayer insulating patterns ILD near to (e.g. adjacent to) the semiconductor substrate 100. For example, the lower separation insulating layer 110 may at least partially cover sidewalls of the two lowermost interlayer insulating patterns ILD. The upper surface of the lower separation insulating layer 110 may be located at a level between two channel patterns SP near to (e.g. adjacent to) the semiconductor substrate 100. For instance, the upper surface of the lower separation insulating layer 110 may be located at a level between the two lowermost channel patterns SP. For instance, the upper surface of the lower separation insulating layer 100 may be located at a level of the second lowermost interlayer insulating pattern ILD. The lower separation insulating layer 110 may be in contact with sidewalls of a lowermost first spacer insulating pattern 41.

The first separation insulating patterns STI1 may penetrate or extend through the first and second stack structures ST1 and ST2 on the semiconductor substrate 100 to extend in the third direction D3. The first separation insulating patterns STI1 may be disposed spaced apart from each other in the first direction D1. The first separation insulating patterns STI1 may be disposed between the first spacer insulating patterns 41 adjacent to each other in the first direction D1. Sidewalls of lower portions of the first separation insulating patterns STI1 may be in contact with the lower separation insulating layer 110.

The first separation insulating patterns STI1 may comprise (e.g. may be) one or more of an insulating material, a silicon oxide layer, and/or a silicon oxynitride layer formed by using spin-on-glass (SOG) technology.

Bottom surfaces of the first separation insulating patterns STI1 may be located at a higher level (D3 direction) than the bottom surface of the lower separation insulating layer 110.

The first separation insulating patterns STI1 may be in contact with a sidewall of the lower separation insulating layer 110 and sidewalls of upper separation insulating patterns 121.

The second separation insulating patterns STI2 may penetrate or extend through the first and second stack structures ST1 and ST2 on the semiconductor substrate 100 to extend in the third direction D3. The second separation insulating patterns STI2 may be disposed spaced apart from each other in the first direction D1, and may be disposed spaced apart from the first separation insulating patterns STI1 in the second direction D2. The second separation insulating patterns STI2 may be disposed between the second spacer insulating patterns 40 adjacent to each other in the first direction D1. A length in the second direction D2 of the second separation insulating pattern STI2 may be greater than a length in the second direction D2 of the first separation insulating pattern STI1. The second separation insulating patterns STI2 may have substantially the same width in the first direction D1 as the first separation insulating patterns STI1.

The second separation insulating patterns STI2 may comprise (e.g. may be) at least one of an insulating material, a silicon oxide layer, and/or a silicon oxynitride layer formed by using spin-on-glass (SOG) technology.

Bottom surfaces of the second separation insulating patterns STI2 may be located at a higher level (D3 direction) than the bottom surface of the lower separation insulating layer 110.

First and second bit lines BLa and BLb may extend in the third direction D3 vertical (D3 direction) to the top surface of the semiconductor substrate 100. The first and second bit lines BLa and BLb may cross the first and second word lines WLa and WLb. Each of the first and second bit lines BLa and BLb may be in contact with first side surfaces of the channel patterns SP spaced apart from each other in the third direction D3. That is, each of the first and second bit lines BLa and BLb may be connected to first dopant regions SD1 of the channel patterns SP stacked along the third direction D3.

The first bit lines BLa may be spaced apart from each other in the first direction D1 on the lower separation insulating layer 110 on one side (e.g. in the second direction D2) of the first stack structure ST1. The second bit lines BLb may be spaced apart from each other in the first direction D1 on the lower separation insulating layer 110 on one side (e.g. in the second direction D2) of the second stack structure ST2.

The second bit lines BLb may be spaced apart from the first bit lines BLa in the second direction D2, and may be disposed spaced apart from each other in the first direction D1. Upper separation insulating patterns 121 may be respectively disposed between the second bit lines BLb adjacent to each other in the first direction D1.

The first and second bit lines BLa and BLb may be spaced apart from a lowermost channel pattern SP. Sidewalls of the first or second bit line BLa or BLb in contact with the first sidewalls of the channel patterns SP may be misaligned with (e.g. offset from) one sidewall of the interlayer insulating patterns ILD (e.g. of the lowermost interlayer insulating pattern(s) ILD) and one sidewall of the lower separation insulating layer 110.

The upper separation insulating patterns 121 may be respectively disposed between the first bit lines BLa adjacent to each other in the first direction D1, and may be respectively disposed between the second bit lines BLb adjacent to each other in the first direction D1.

The upper separation insulating patterns 121 may be respectively disposed on the lower separation insulating layers 110. The upper separation insulating patterns 121 may include an insulating material different from the lower separation insulating layer 110. For example, an upper separation insulating layer 120 may be one among a silicon oxide layer, a silicon nitride layer, and/or a silicon oxynitride layer.

The upper separation insulating patterns 121 may be in contact with the first separation insulating patterns STI1.

The data storage element DS may be in contact with a second side surface of each channel pattern SP. According to embodiments, the data storage element DS may be a capacitor, and the data storage element DS may include a storage electrode SE, the plate electrode PE and a capacitor dielectric layer CIL therebetween. A corresponding data storage element DS may be connected to each channel pattern SP. This may provide a one transistor one capacitor (1T1C) arrangement. While embodiments are described herein that make use of capacitors as data storage elements DS, alternative data storage elements may be utilized (such as resistive memory cells, phase change memory cells or magnetic tunnel junctions). Accordingly, the semiconductor memory device may be any form of memory device, such as a non-volatile memory device (e.g. flash memory, magnetic RAM, resistive RAM, phase change memory, etc.) or volatile memory device (e.g. DRAM).

A storage electrode SE may be in contact with the second side surface of each channel pattern SP. The storage electrodes SE may be provided at substantially the same level as the channel patterns SP. In other words, the storage electrodes SE may be stacked in the third direction D3, and may have a long axis in the second direction D2. That is, each storage electrode SE may extend or protrude in the second direction D2 (e.g. the longest axis of the storage electrode SE may be in the second direction D2). Each storage electrode SE may include an inner space within which at least a portion of the capacitor dielectric layer CIL and at least a portion of the plate electrode PE are received. Each storage electrode SE may have a square internal and external cross-section when in cross-section along the second direction D2 and third direction D3 (as shown in FIG. 1C). The storage electrodes SE may be respectively disposed between the interlayer insulating patterns ILD vertically (D3 direction) adjacent thereto. The second separation insulating patterns STI2 may be respectively disposed between the storage electrodes SE adjacent to each other in the first direction D1.

The capacitor dielectric layer CIL may conformally cover at least some surfaces of the storage electrodes SE. The plate electrode PE may at least partially fill inner spaces of the storage electrodes SE on which the capacitor dielectric layer CIL is formed. The plate electrode PE may include a plurality of protrusions protruding in the second direction D2 and spaced apart from each other in the first direction D1 and third direction D3. Each protrusion may protrude into the inner space of a corresponding storage electrode SE.

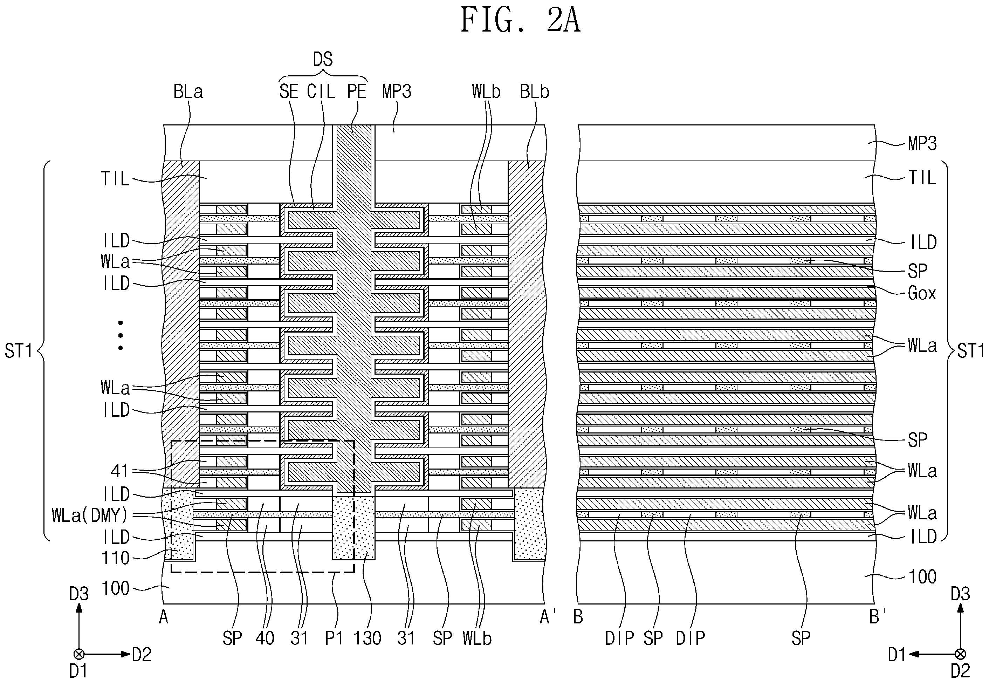

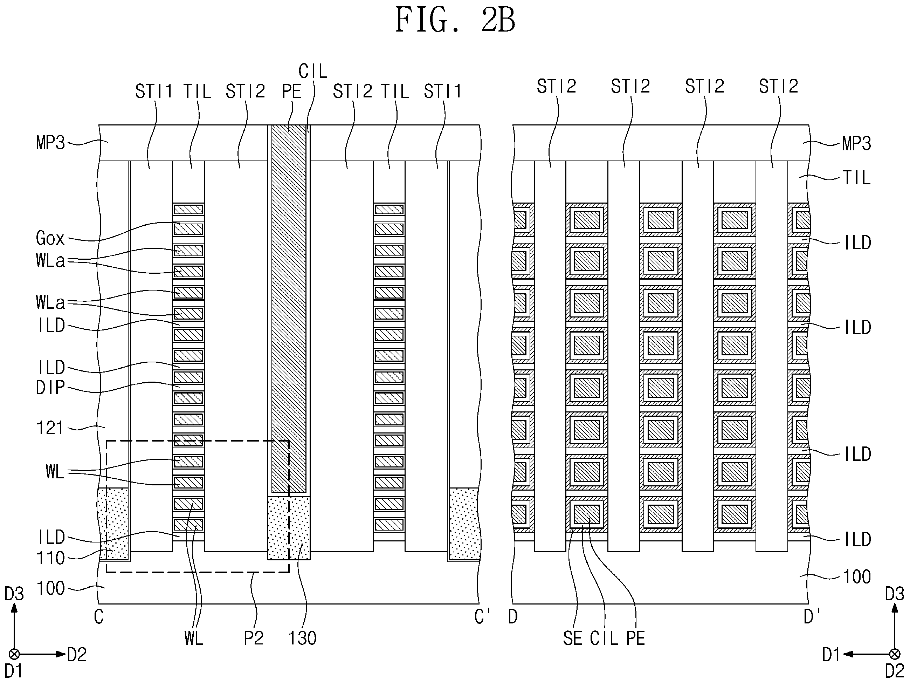

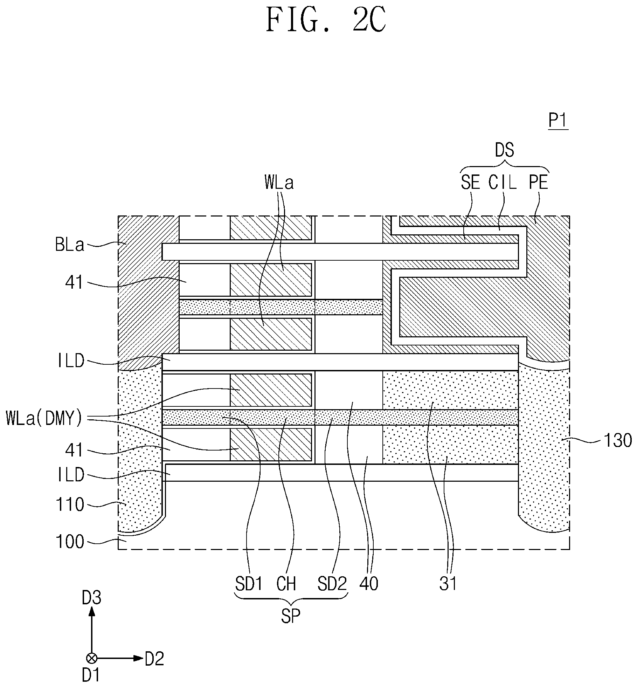

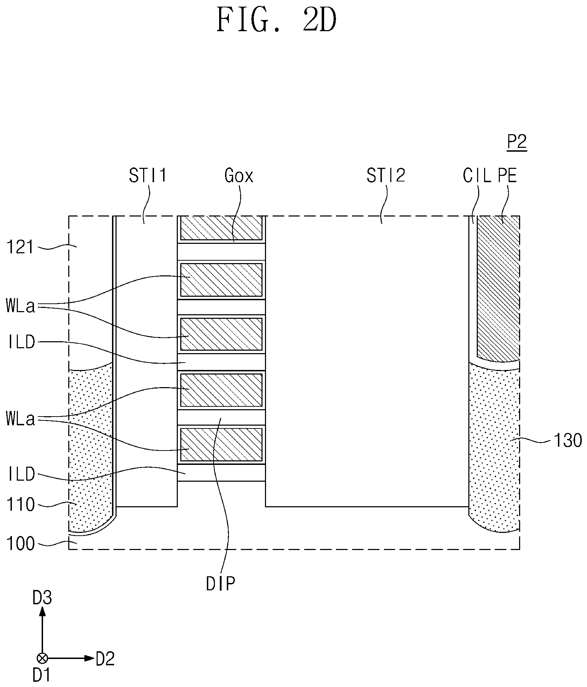

FIG. 2A is a cross-sectional view taken along line A-A' and line B-B' of FIG. 1A to illustrate a cell array structure of a semiconductor memory device according to embodiments of the inventive concept. FIG. 2B is a cross-sectional view taken along line C-C' and line D-D' of FIG. 1A to illustrate a cell array structure of a semiconductor memory device according to embodiments of the inventive concept. FIG. 2C is an enlarged views of portion 'P1' of FIG. 2A. FIG. 2D is an enlarged views of portion 'P2' of FIG. 2B.

The same reference numerals or symbols as those illustrated in FIGS. 1A to 1E indicate the same component in embodiments illustrated in FIGS. 2A, 2B, 2C and 2D. To simplify description, description of the same technological features as the semiconductor memory device described above may be omitted, and differences between embodiments will be described.

Referring to FIGS. 2A and 2B, as described above, the semiconductor memory device may include the semiconductor substrate 100, the first and second stack structures ST1 and ST2, the channel patterns SP, the first and second bit lines BLa and BLb, and the data storage element DS.

In addition, the semiconductor memory device may further include the first lower separation insulating layers 110 disposed on one side of the first and second stack structures ST1 and ST2 on the semiconductor substrate 100, a second lower separation insulating layer 130 between the first and second stack structures ST1 and ST2 on the semiconductor substrate 100, and the upper separation insulating patterns 121 disposed on each first lower separation insulating layer 110.

The first lower separation insulating layers 110 may correspond to the same component as the lower separation insulating layer described above, and the second lower separation insulating layer 130 may be disposed between the plate electrode PE of the data storage element DS and the semiconductor substrate 100.

The second lower separation insulating layer 130 may extend parallel to the first and second stack structures ST1 and ST2 in the first direction D1. The second lower separation insulating layer 130 may be on and at least partially cover the second side surface of at least one channel pattern (e.g. at least one lowermost channel pattern) among the channel patterns SP. The second lower separation insulating layer 130 may include an insulating material different from the interlayer insulating patterns ILD. The second lower separation insulating layer 130 may be formed of an insulating material having a lower dielectric constant than a silicon oxide layer. The second lower separation insulating layer 130 may be composed of an insulating material including carbon. A content of carbon may be about 5% to about 60% in the second lower separation insulating layer 130.

The second lower separation insulating layer 130 may have a rounded upper surface and a rounded bottom surface. The bottom surface may be convex (e.g. may be rounded outwards, e.g. towards the semiconductor substrate 100). The upper surface may be concave (e.g. may be rounded inwards, e.g. towards the semiconductor substrate 100). The bottom surface of the second lower separation insulating layer 130 may be located at a lower level (D3 direction) than a lowermost interlayer insulating pattern among the interlayer insulating patterns ILD.

As described above, the first spacer insulating patterns 41 may be disposed on a first end portion of each of the channel patterns SP, and the second spacer insulating patterns 40 may be disposed on a second end portion of each of the channel patterns SP.

In addition, according to some embodiments, at least one channel pattern SP adjacent to the second lower separation insulating layer 130 may be longer in the second direction D2 than the channel patterns SP connected to the data storage element DS.

Dummy insulating patterns 31 may be disposed between a sidewall of the second lower separation insulating layer 130 and the second spacer insulating patterns 40. The dummy insulating patterns 31 may include a silicon nitride layer and/or a silicon oxynitride layer.

According to some embodiments, an upper surface of the first lower separation insulating layer 110 may be located at a different level (D3 direction) from an upper surface of the second lower separation insulating layer 130. In addition, a bottom surface of the first lower separation insulating layer 110 may be located at a different level (D3 direction) from a bottom surface of the second lower separation insulating layer 130.

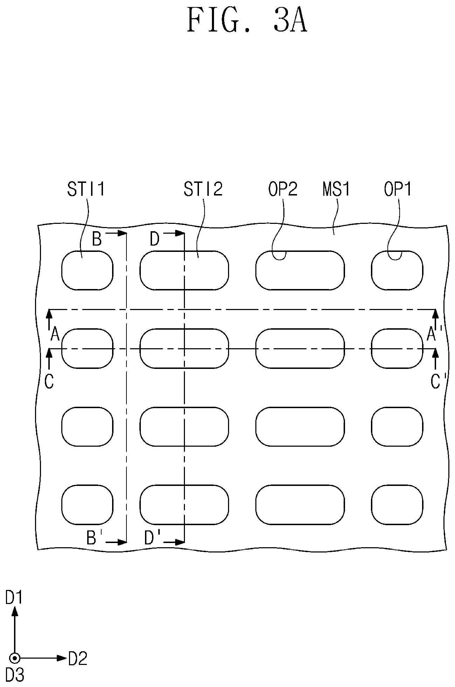

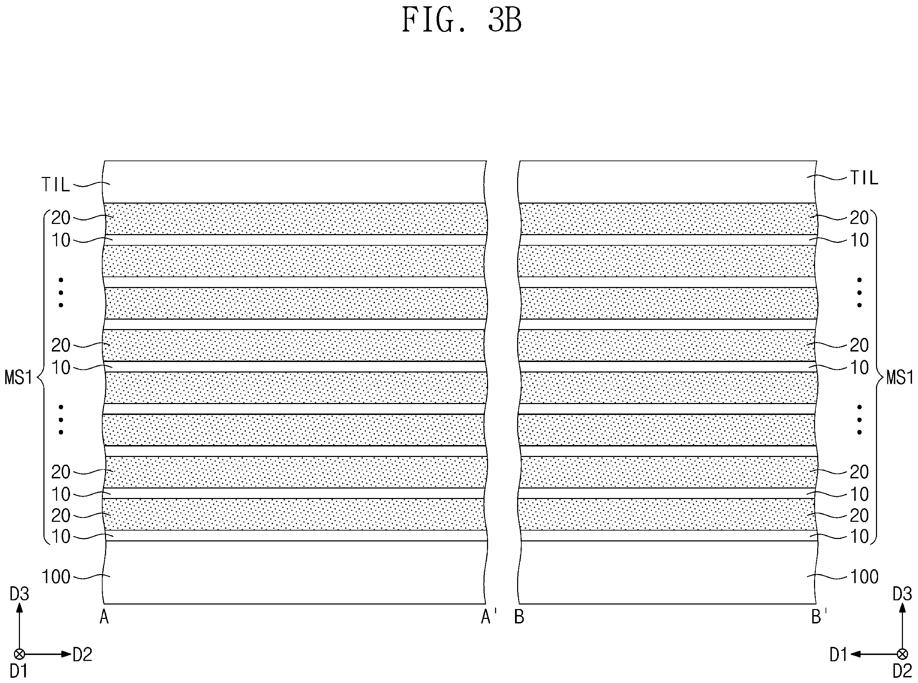

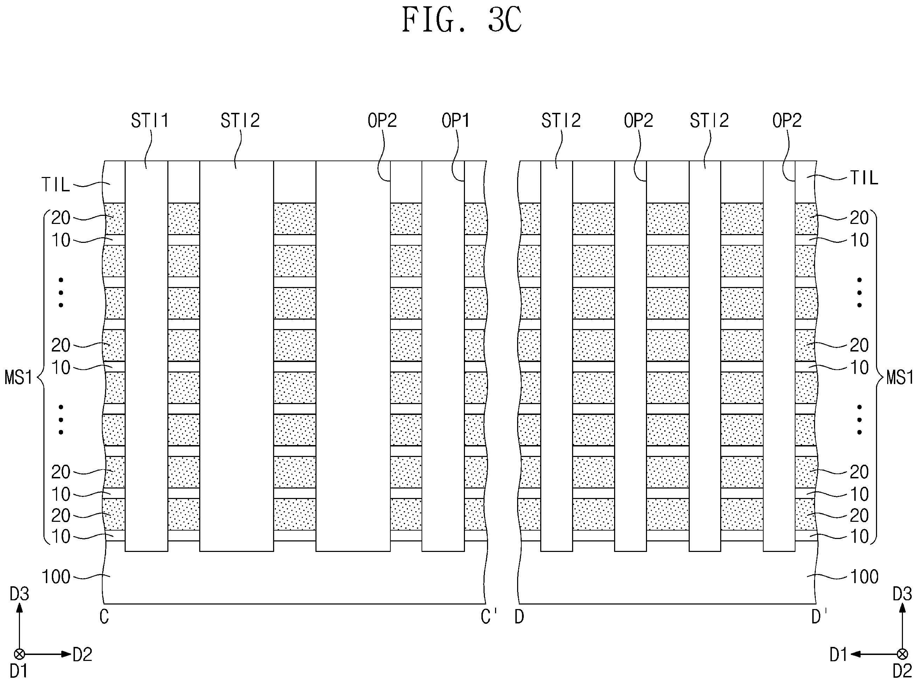

FIGS. 3A, 4A, 5A, 6A, 7A, 8A, 9A, 10A, 11A, 12A, 13A, 14A, 15A, 16A, and 17A are plan views illustrating a method for manufacturing a semiconductor memory device according to embodiments of the inventive concept. FIGS. 3B, 4B, 5B, 6B, 7B, 8B, 9B, 10B, 11B, 12B, 13B, 14B, 15B, 16B, and 17B are cross-sectional views taken along line A-A' and line B-B' of FIGS. 1A, 2A, 3A, 4A, 5A, 6A, 7A, 8A, 9A, 10A, 11A, 12A, 13A, 14A, 15A, 16A, and 17A to illustrate a method for manufacturing a semiconductor memory device according to embodiments of the inventive concept, and show cross-sections. FIGS. 3C, 4C, 5C, 6C, 7C, 8C, 9C, 10C, 11C, 12C, 13C, 14C, 15C, 16C, and 17C are cross-sectional views taken along line C-C' and line D-D' of FIGS. 1A, 2A, 3A, 4A, 5A, 6A, 7A, 8A, 9A, 10A, 11A, 12A, 13A, 14A, 15A, 16A, and 17A to illustrate a method for manufacturing a semiconductor memory device according to embodiments of the inventive concept.

Referring to FIGS. 3A, 3B, and 3C, a first mold structure MS1 may be formed on a semiconductor substrate 100.

The semiconductor substrate 100 may include a semiconductor material (for example, a silicon wafer). In other embodiments, instead of the semiconductor substrate 100, an insulating material (for example, glass), or one of a semiconductor or conductor at least partially covered by the insulating material may be used as the substrate.

The first mold structure MS1 including first sacrificial layers 10 and semiconductor layers 20 alternately stacked on the semiconductor substrate 100 may be formed.

The first sacrificial layers 10 may be formed of a material having etch selectivity with respect to the semiconductor layers 20. For example, the first sacrificial layers 10 may be formed of at least one of a silicon-germanium layer, a silicon oxide layer, a silicon nitride layer, and/or a silicon oxynitride layer. According to embodiments, the first sacrificial layers 10 may be a semiconductor material, for example, a silicon-germanium layer. When the first mold structure MS1 is formed, each first sacrificial layer 10 may have a smaller thickness than each semiconductor layer 20.

For example, the semiconductor layers 20 may include silicon, germanium, silicon-germanium, and/or indium-gallium-zinc oxide (IGZO). According to embodiments, the semiconductor layers 20 may include the same semiconductor material as the semiconductor substrate 100. For example, the semiconductor layers 20 may be a single-crystalline silicon layer or a polycrystalline silicon layer.

According to embodiments, the first sacrificial layers 10 and the semiconductor layers 20 may be formed by performing an epitaxial growth process. The semiconductor layers 20 may be the single-crystalline silicon layers, and the sacrificial layers may be the silicon-germanium layer having a super-lattice structure.

An upper insulating layer TIL at least partially covering an uppermost semiconductor layer 20 may be formed on the first mold structure MS1. The upper insulating layer TIL may comprise an insulating material having etch selectivity with respect to the first sacrificial layers 10 and the semiconductor layers 20. For example, the upper insulating layer TIL may be a silicon oxide layer.

Successively, first and second openings OP1 and OP2 at least partially exposing the semiconductor substrate 100 may be formed by patterning the upper insulating layer TIL and the first mold structure MS1.

Forming the first and second openings OP1 and OP2 may include forming, on the upper insulating layer TIL, a mask pattern (not shown) having openings corresponding to the first and second openings OP1 and OP2, and anisotropically etching the first mold structure MS1 by using the mask pattern as an etching mask.

The first and second openings OP1 and OP2 may at least partially expose a top surface of the semiconductor substrate 100, and the top surface of the semiconductor substrate 100 exposed to the first and second openings OP1 and OP2 may be recessed by over-etching during the anisotropic etching.

The first openings OP1 may be formed spaced apart from each other along the first direction D1. The second openings OP2 may be formed spaced apart from each other along the first direction D1, and may be spaced apart from the first openings OP1 in the second direction D2. A pair of second openings OP2 may be formed between a pair of first openings OP1.

The first and second openings OP1 and OP2 may be spaced apart from each other with a first interval in the first direction D1. The first openings OP1 may be spaced apart from the second openings OP2 with a second interval smaller than the first interval in the second direction D2.

The first and second openings OP1 and OP2 may each have a first width in the first direction D1. In the second direction D2, the first openings OP1 may have a first length, and the second openings OP2 may have a second length greater than the first length.

The first and second openings OP1 and OP2 may be respectively at least partially filled with first and second separation insulating patterns STI1 and STI2.

The first and second separation insulating patterns STI1 and STI2 may be in contact with the semiconductor substrate 100. The first and second separation insulating patterns STI1 and STI2 may comprise (e.g. may be) at least one of an insulating material, a silicon oxide layer, and/or a silicon oxynitride layer formed by using spin-on-glass (SOG) technology. The first and second separation insulating patterns STI1 and STI2 may be formed by depositing a separation insulating layer to at least partially fill the first and second openings OP1 and OP2, and planarizing the separation insulating layer to at least partially expose an upper surface of the upper insulating layer TIL.

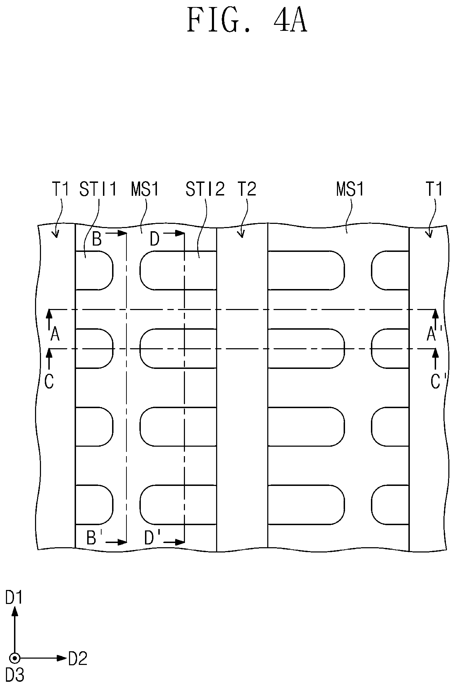

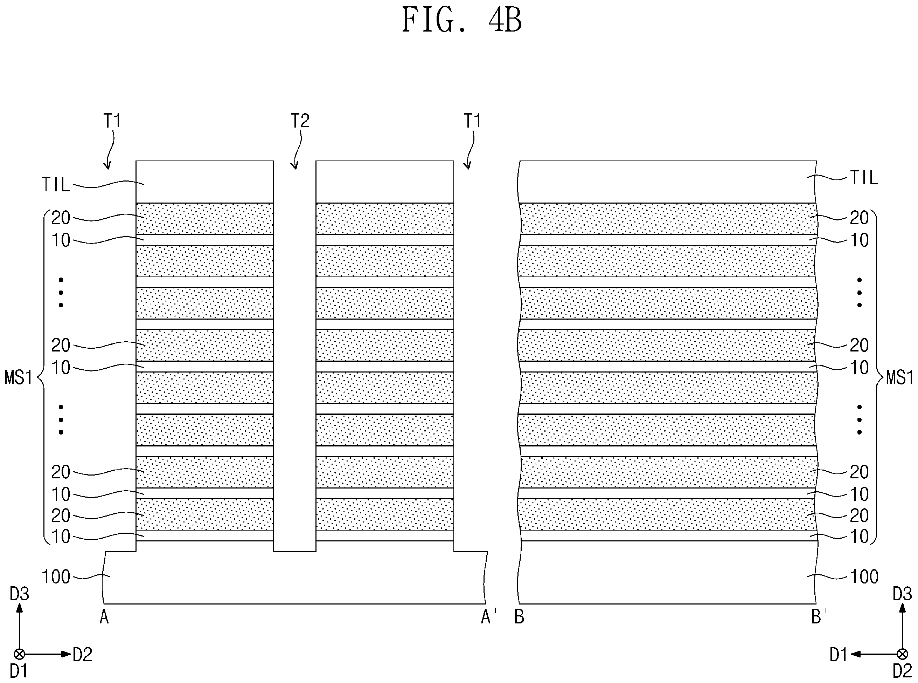

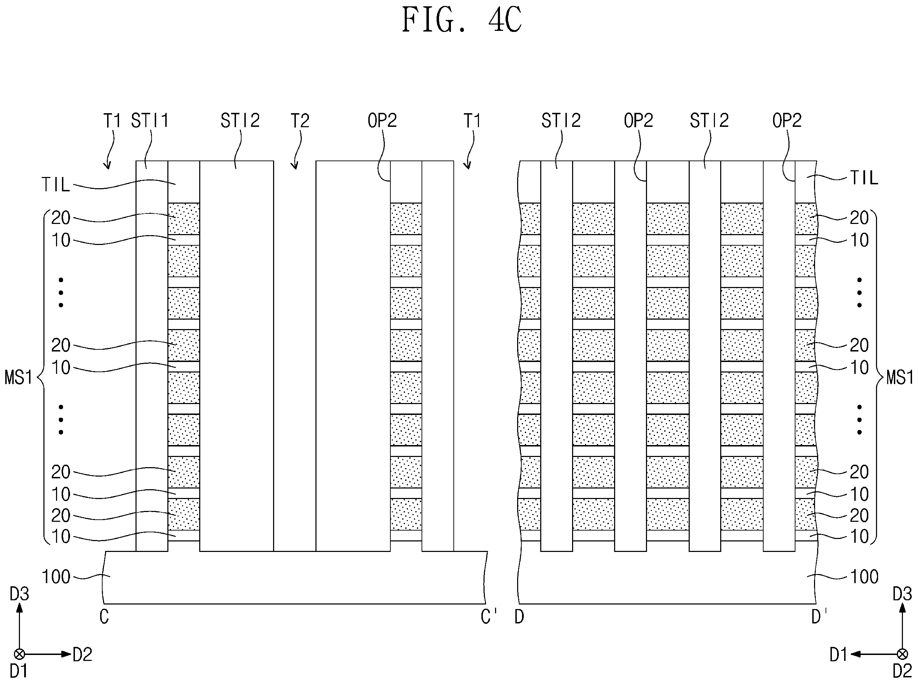

Referring to FIGS. 4A, 4B and 4C, first and second trenches T1 and T2 penetrating or extending through the first mold structure MS1 to expose sidewalls of the first sacrificial layers 10 and the semiconductor layers 20 may be formed.

Forming the first and second trenches T1 and T2 may include forming, on the first mold structure MS1, a mask pattern (not shown) having openings corresponding to the first and second trenches T1 and T2, and anisotropically etching the first mold structure MS1 by using the mask pattern as an etching mask. The first and second trenches T1 and T2 may at least partially expose the top surface of the semiconductor substrate 100, and a recess region may be formed by recessing the top surface of the semiconductor substrate 100 under the first and second trenches T1 and T2 by overetching during the anisotropic etching.

The first and second trenches T1 and T2 may extend parallel to each other in the first direction D1. The first and second trenches T1 and T2 may at least partially expose sidewalls of the first sacrificial layers 10 and sidewalls of the semiconductor layers 20. In addition, the first trenches T1 may extend along the first direction D1 to at least partially expose sidewalls of the first separation insulating patterns STI1.

The second trenches T2 may be formed between a pair of first trenches T1, and may extend along the first direction D1 to at least partially expose sidewalls of the second separation insulating patterns STI2.

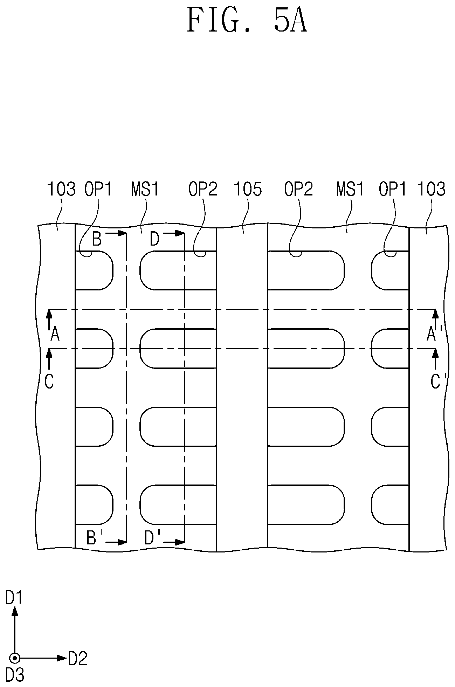

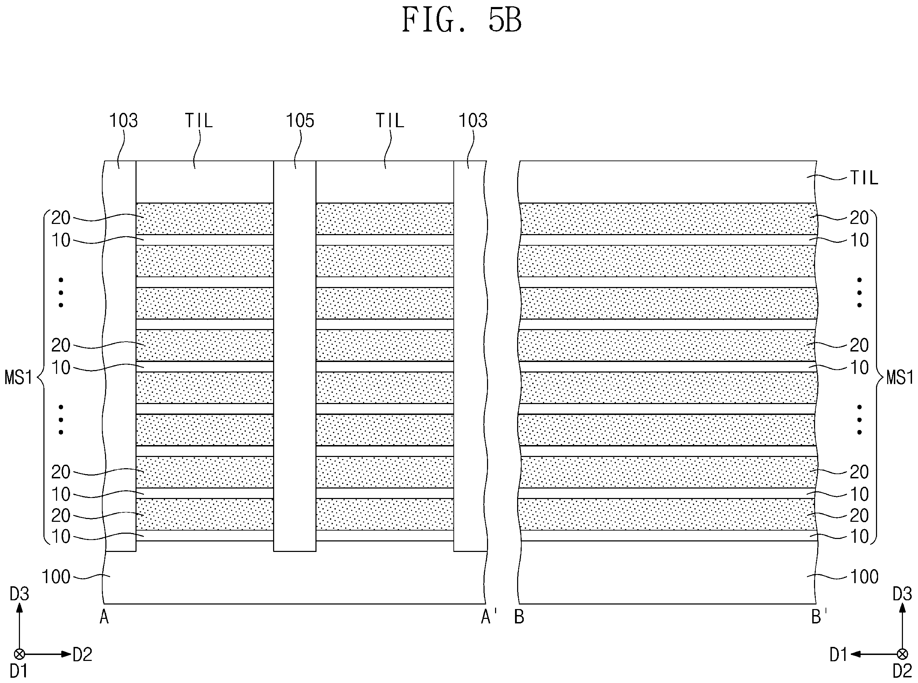

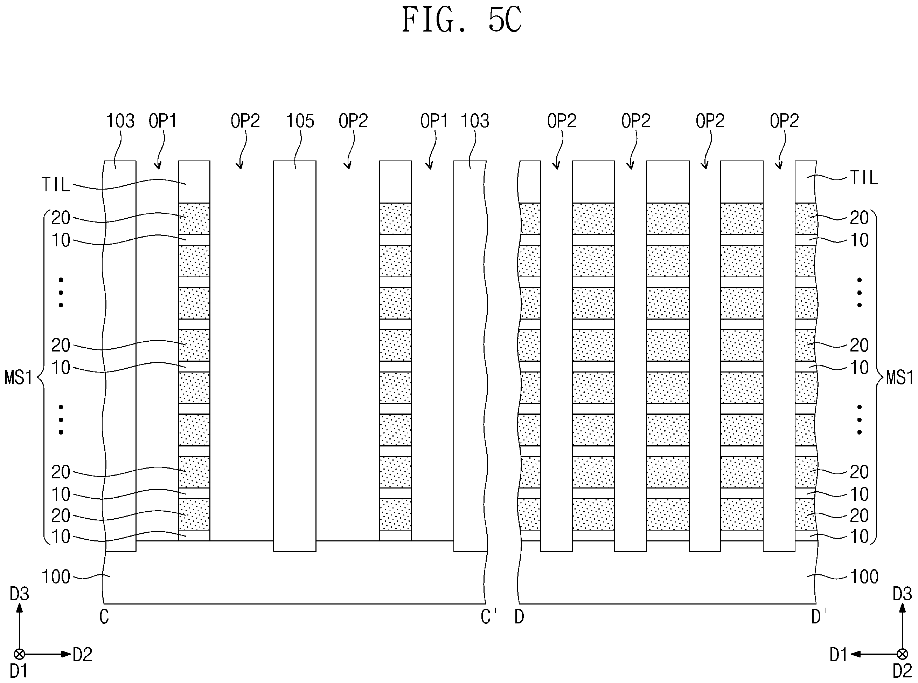

Referring to FIGS. 5A, 5B and 5C, first sacrificial line patterns 103 may be formed in the first trenches T1, and a second sacrificial line pattern 105 may be formed in the second trench T2. The first and second sacrificial line patterns 103 and 105 may be on and at least partially cover the sidewalls of the first sacrificial layers 10 and the semiconductor layers 20.

Forming the first and second sacrificial line patterns 103 and 105 may include forming a buried insulating layer that at least partially fills the first and second openings OP1 and OP2, and then at least partially exposing an upper surface of the upper insulating layer TIL by planarizing the buried insulating layer. Planarizing the buried insulating layer may be performed by using planarizing technology, such as chemical mechanical polishing (CMP) or etch-back.

For example, the first and second sacrificial line patterns 103 and 105 may include at least one of a silicon oxide layer, a silicon nitride layer, and/or a silicon oxynitride layer. The first and second sacrificial line patterns 103 and 105 may be composed of a single layer or a multiple layer.

After the first and second sacrificial line patterns 103 and 105 are formed, the first and second separation insulating patterns STI1 and STI2 may be removed. Accordingly, the first and second openings OP1 and OP2 penetrating or extending through the first mold structure MS1 may be formed again. That is, the sidewalls of the first sacrificial layers 10 and the semiconductor layers 20 and sidewalls of the first and second sacrificial line patterns 103 and 105 may be at least partially exposed in the first and second openings OP1 and OP2.

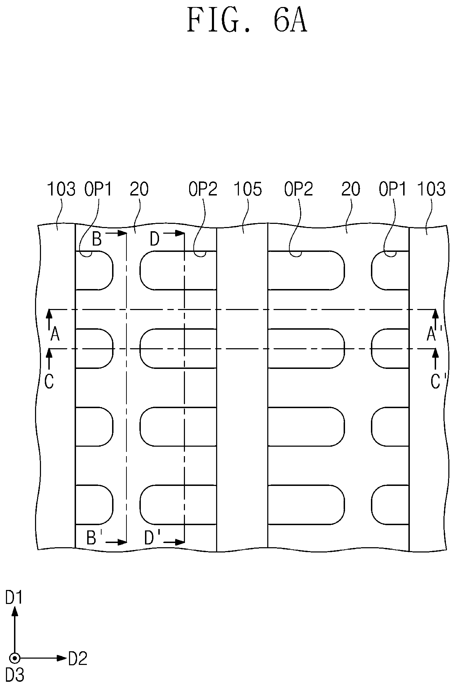

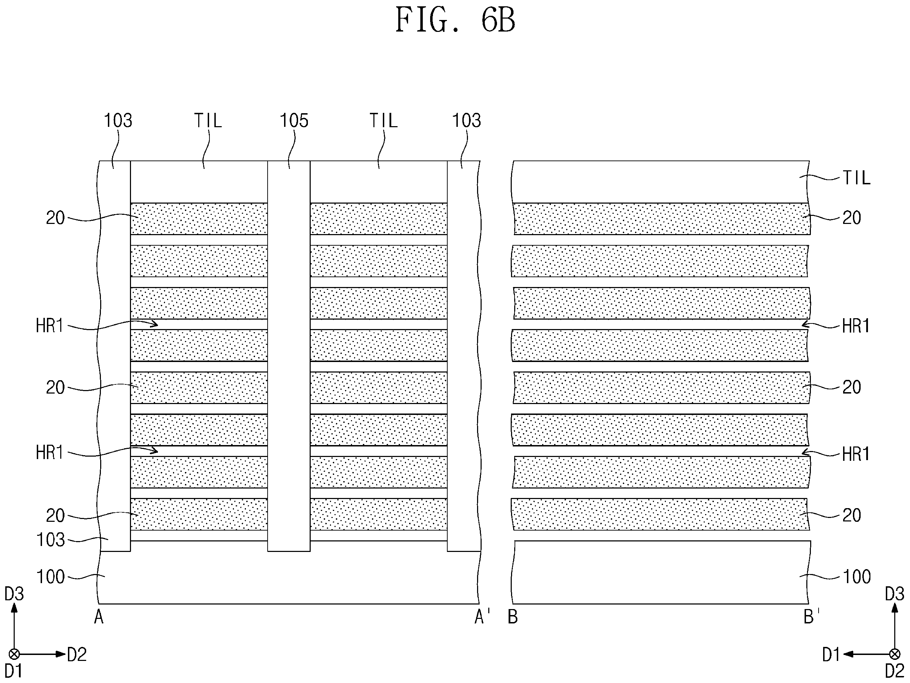

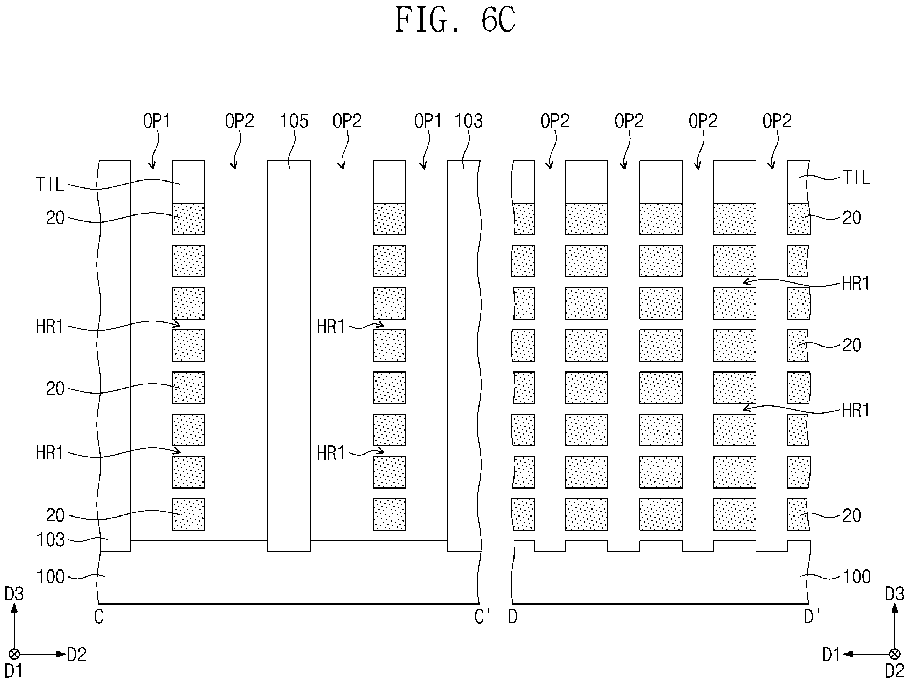

Referring to FIGS. 6A, 6B and 6C, first horizontal regions HR1 may be formed between the semiconductor layers 20 vertically (D3 direction) adjacent to each other by removing the first sacrificial layers 10 exposed to the first and second openings OP1 and OP2.

Forming the first horizontal regions HR1 may include isotropically etching the first sacrificial layers 10 by performing an etching process having etch selectivity with respect to the semiconductor substrate 100, the semiconductor layers 20 and the first and second sacrificial line patterns 103 and 105. When the first sacrificial layers 10 are removed, the semiconductor layers 20 may be supported by the first and second sacrificial line patterns 103 and 105 (and therefore may not collapse), and may be vertically (D3 direction) spaced apart from each other.

A vertical thickness of the first horizontal region HR1, in other words, a vertical distance (D3 direction) between the semiconductor layers 20 adjacent to each other may be substantially the same as a thickness of the first sacrificial layer 10.

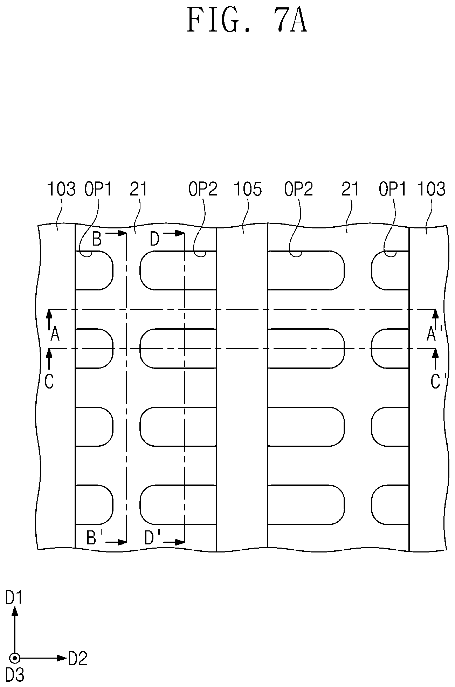

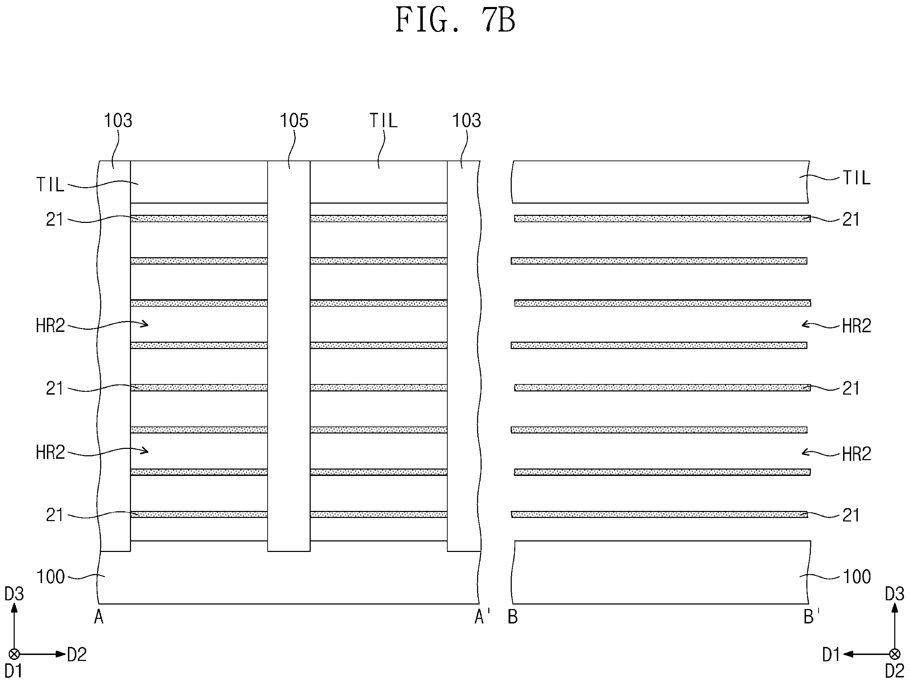

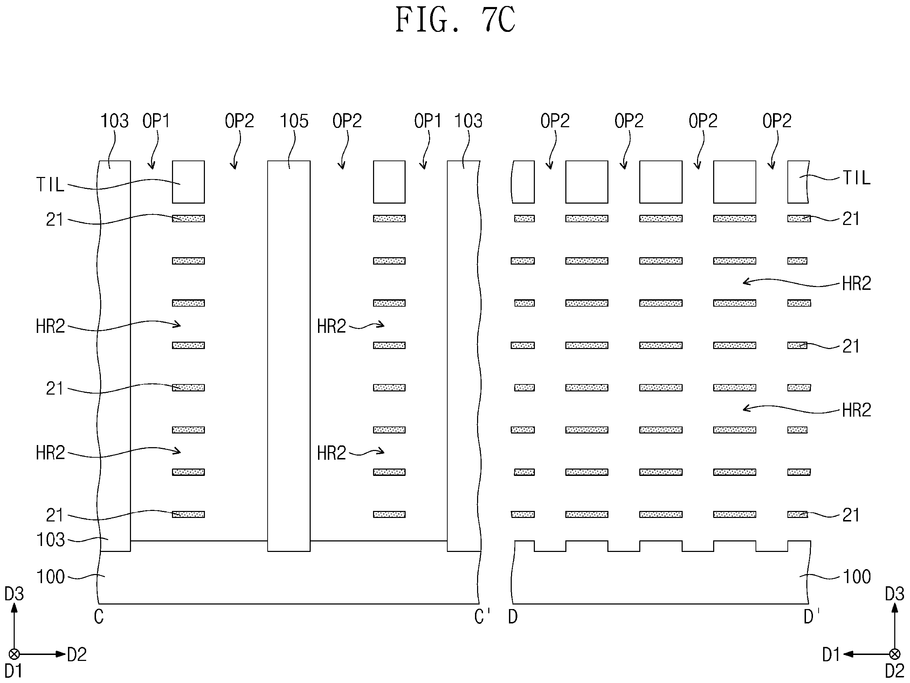

Referring to FIGS. 7A, 7B and 7C, an enlargement process by which the vertical (D3 direction) thicknesses of the first horizontal regions HR1 are increased may be performed.

For example, the enlargement process may include etching upper surfaces and lower surfaces of the semiconductor layers 20 exposed to the first horizontal regions HR1. For example, the enlargement process may include performing an isotropic etching process having etch selectivity with respect to the upper insulating layer TIL and the first and second sacrificial line patterns 103 and 105.

Preliminary channel layers 21 may be formed by reducing a thickness of each of the semiconductor layers 20 by performing a trimming process. Simultaneously, second horizontal regions HR2 may be respectively formed between the preliminary channel layers 21 vertically

(D3 direction) adjacent to each other by increasing vertical (D3 direction) thicknesses of the first horizontal regions HR1.

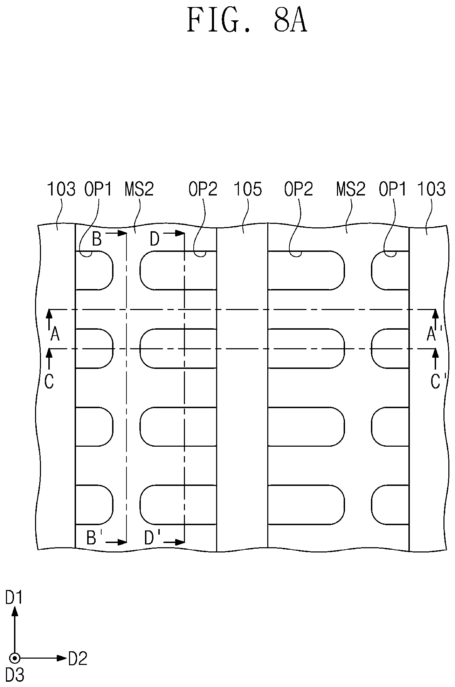

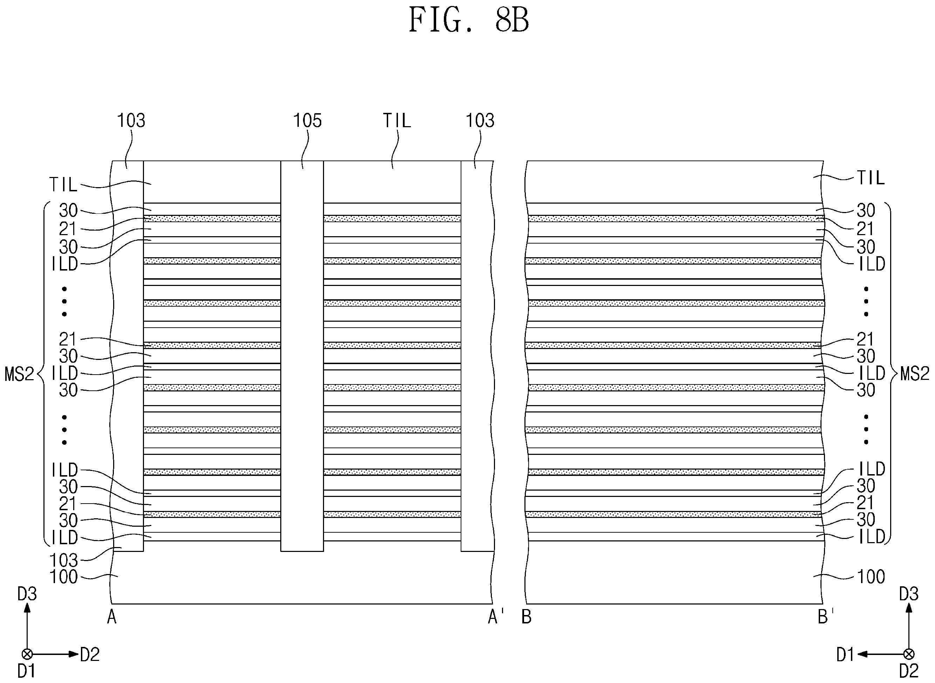

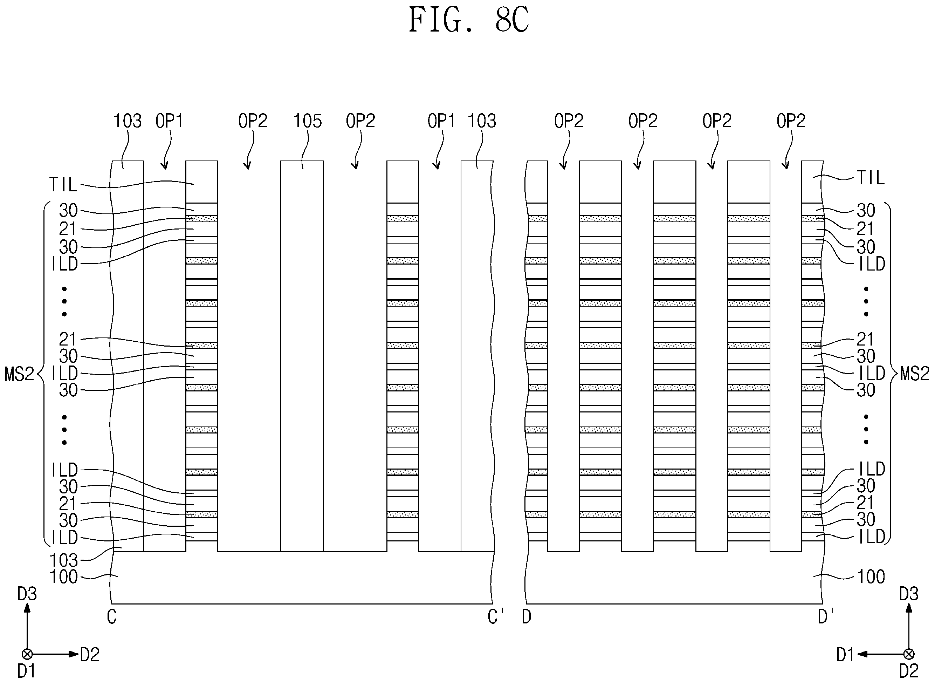

Referring to FIGS. 8A, 8B and 8C, a second mold structure MS2 may be formed on the semiconductor substrate 100 by successively depositing a second sacrificial layer and an interlayer insulating layer on surfaces of the preliminary channel layers 21, and then successively performing a process of partially etching the interlayer insulating layer and the second sacrificial layer. The second mold structure MS2 may include second sacrificial layers 30 and the interlayer insulating patterns ILD therebetween between the preliminary channel layers 21 vertically (D3 direction) adjacent to each other.

More specifically, when the second mold structure MS2 is formed, the second sacrificial layer may be deposited in a smaller thickness than a half of a vertical (D3 direction) thickness of the second horizontal region HR2. Accordingly, after the second sacrificial layer is deposited, gap regions may be defined between the preliminary channel layers 21 vertically adjacent to each other. Continuously, the interlayer insulating layer may be formed on the second sacrificial layer to at least partially fill the second horizontal regions HR2 in which the second sacrificial layer is formed.

After the interlayer insulating layer is formed, the interlayer insulating patterns ILD may be formed by partially etching the interlayer insulating layer exposed to the first and second openings OP1 and OP2. The interlayer insulating patterns ILD may include isotropically etching the interlayer insulating layer until the sacrificial layer is exposed to the first and second openings OP1 and OP2. The interlayer insulating patterns ILD may be vertically (D3 direction) separated by the isotropic etching process.

The second sacrificial layers 30 vertically (D3 direction) separated from each other may be formed by performing a process of isotropically etching the sacrificial layer in the first and second openings OP1 and OP2. The process of isotropically etching the sacrificial layer may be performed until sidewalls of the preliminary channel layers 21 are exposed to the first and second openings OP1 and OP2. That is, after the second mold structure MS2 is formed, the sidewalls of the preliminary channel layers 21, sidewalls of the second sacrificial layers 30 and sidewalls of the interlayer insulating patterns ILD may be exposed to the first and second openings OP1 and OP2.

The second sacrificial layers 30 may be formed of a material having etch selectivity with respect to the semiconductor substrate 100 and the preliminary channel layers 21. For example, the second sacrificial layers 30 may be formed of at least one of a silicon oxide layer, a silicon nitride layer, and/or a silicon oxynitride layer.

The interlayer insulating patterns ILD may be composed of an insulating material having etch selectivity with respect to the second sacrificial layers 30 and the semiconductor substrate 100. For example, the interlayer insulating patterns ILD may include silicon oxide.

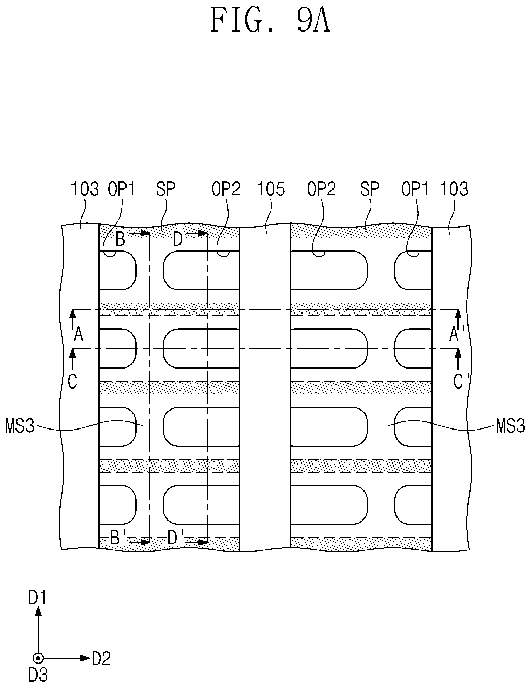

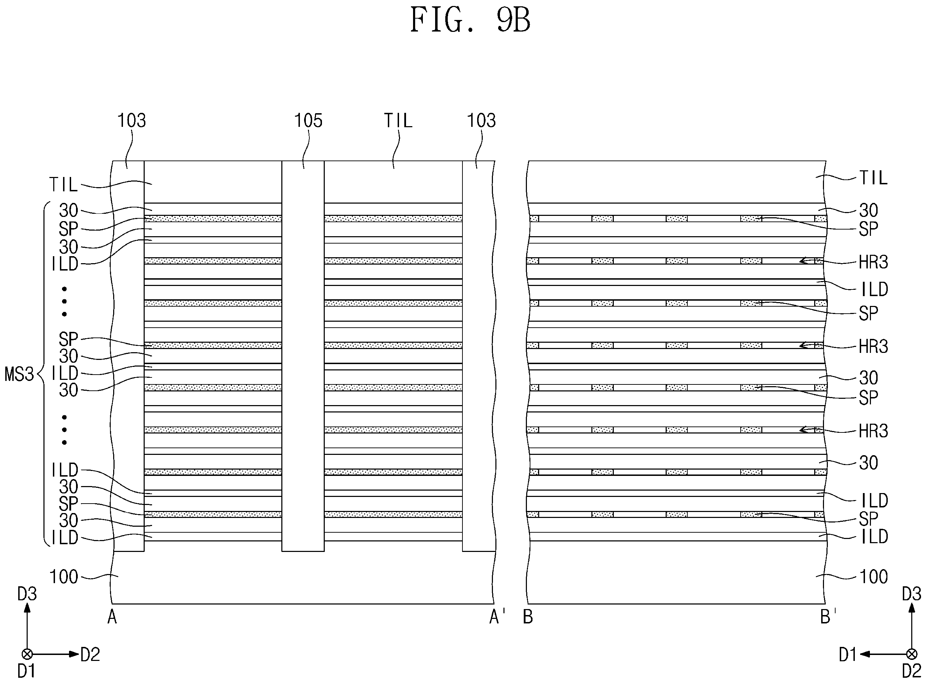

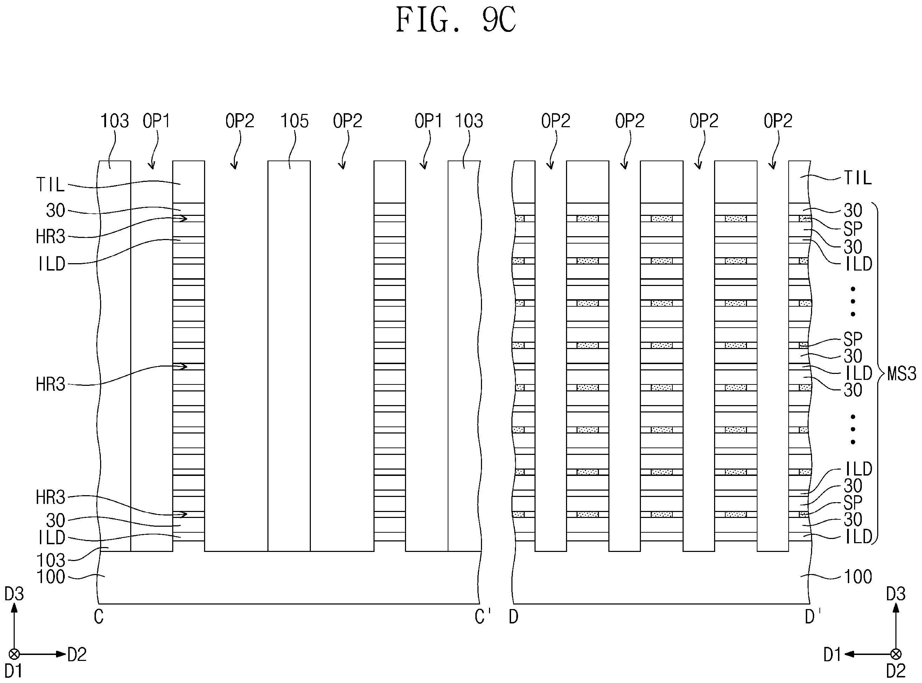

Referring to FIGS. 9A, 9B and 9C, a process of etching some portions of the preliminary channel layers 21 exposed to the first and second openings OP1 and OP2 may be performed. Accordingly, channel patterns SP separated from each other in the first direction D1 may be formed.

Forming the channel patterns SP may include isotropically etching the preliminary channel layers 21 exposed to the first and second openings OP1 and OP2. That is, etchant may be supplied through the first and second openings OP1 and OP2 to laterally etch the preliminary channel layers 21 along the first direction D1 and the second direction D2. In this case, because a distance between the first openings OP1 and a distance between the second openings OP2 are greater than a distance between the first and second openings OP1 and OP2, some portions of the preliminary channel layers 21 may be separated in the first direction D1 to form the channel patterns SP. As a result of the isotropic etching process, a width in the first direction D1 of each of the channel patterns SP may be greater in the center than at the sidewall(s). In other embodiments, each of the channel patterns SP may have a uniform width in the first direction D1.

Third horizontal regions HR3 at least partially exposing sidewalls of the channel patterns SP may be formed between the second sacrificial layers 30 by forming the channel patterns SP. The third horizontal regions HR3 may correspond to a region in which the preliminary channel layers 21 are etched.

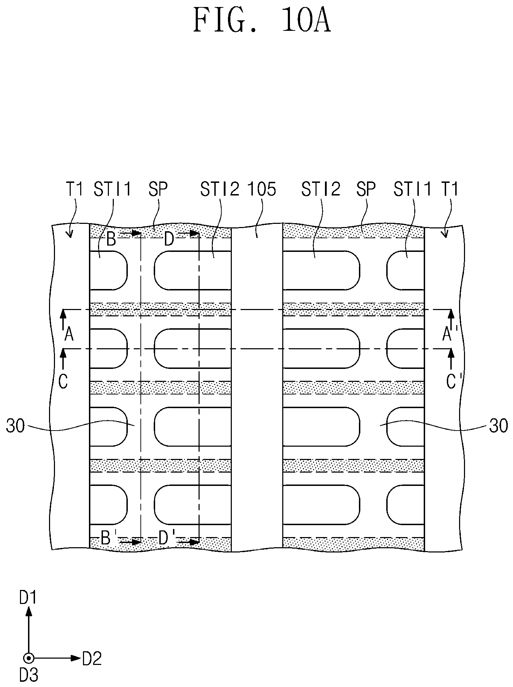

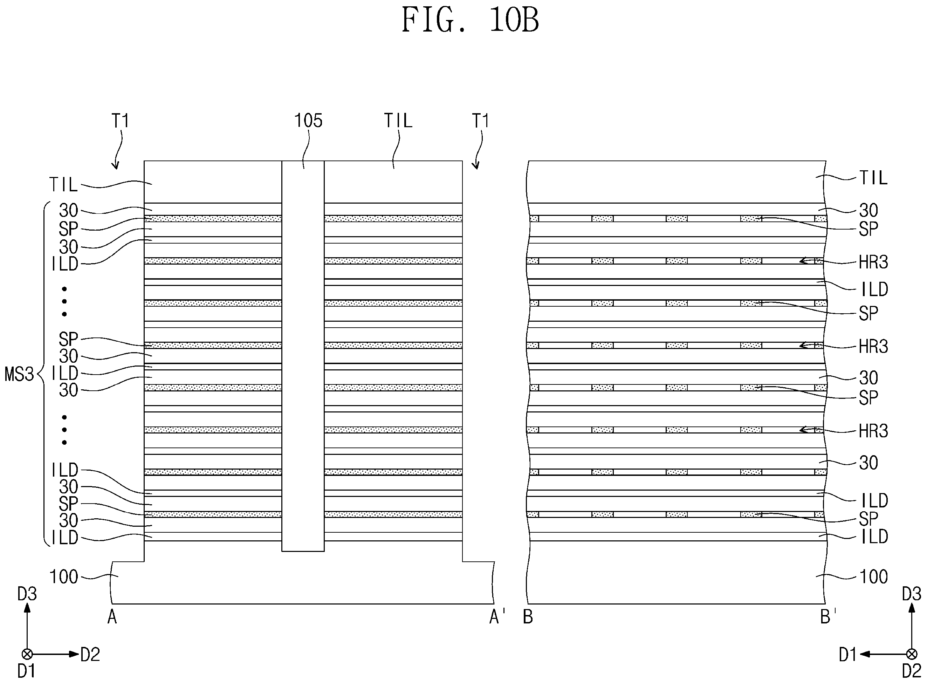

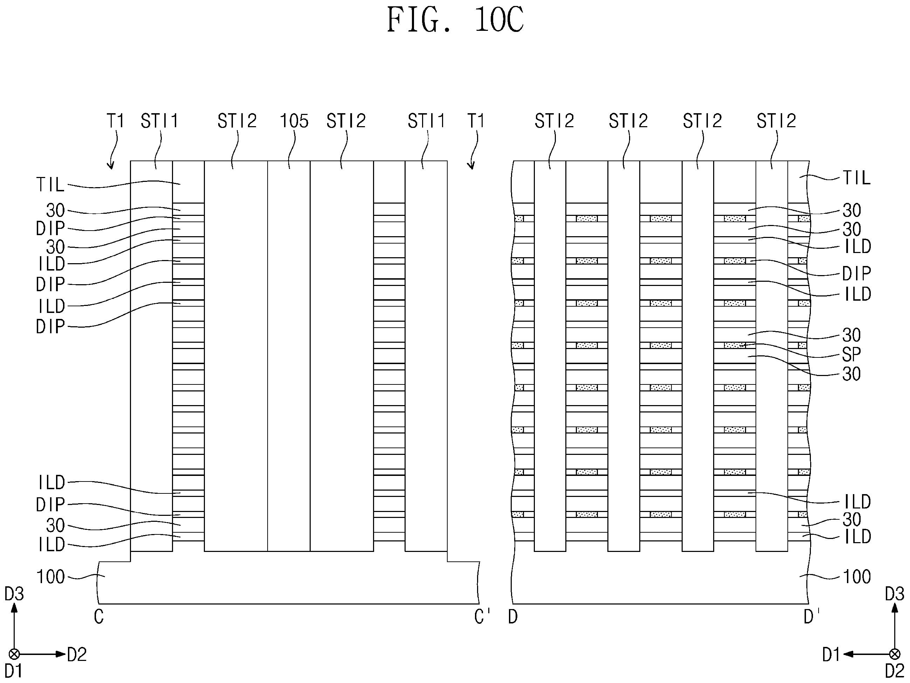

Referring to FIGS. 10A, 10B and 10C, after the channel patterns SP are formed, the first and second openings OP1 and OP2 may be respectively at least partially filled with the first and second separation insulating patterns STI1 and STI2.

The first and second separation insulating patterns STI1 and STI2 may be in contact with the semiconductor substrate 100. The first and second separation insulating patterns STI1 and STI2 may comprise (e.g. may be) at least one of an insulating material, a silicon oxide layer, and/or a silicon oxynitride layer formed by using spin-on-glass (SOG) technology. The first and second separation insulating patterns STI1 and STI2 may be formed by depositing a separation insulating layer to at least partially fill the first and second openings OP1 and OP2, and planarizing the separation insulating layer to at least partially expose an upper surface of the upper insulating layer TIL.

When the first and second separation insulating patterns STI1 and STI2 are formed, the third horizontal regions HR3 may be at least partially filled with an insulating material. Accordingly, dummy insulating patterns DIP may be formed between the channel patterns SP adjacent to each other in the first direction D1.

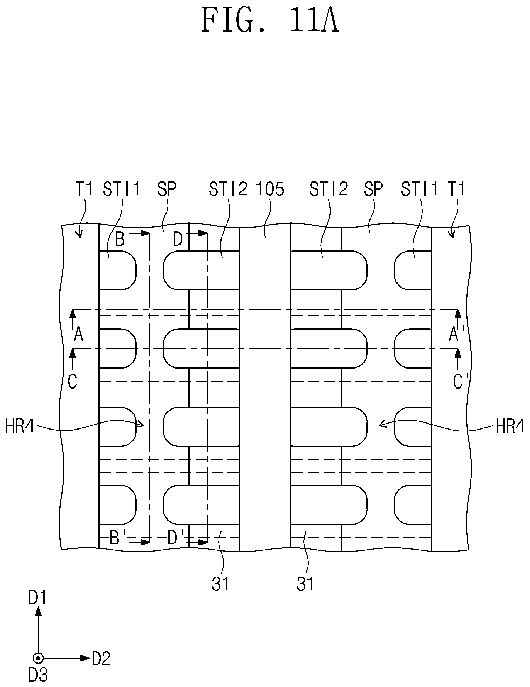

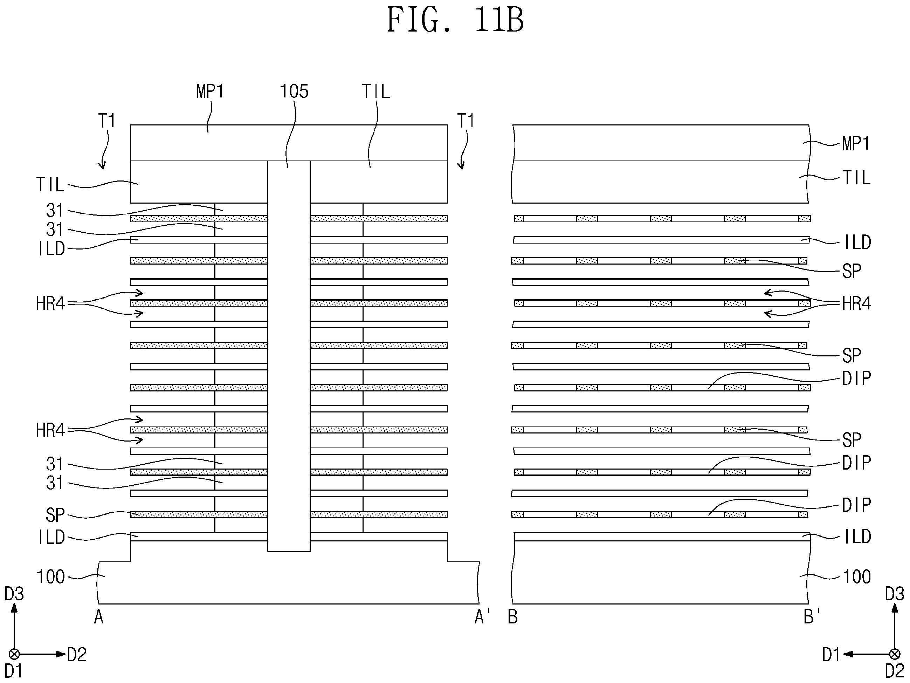

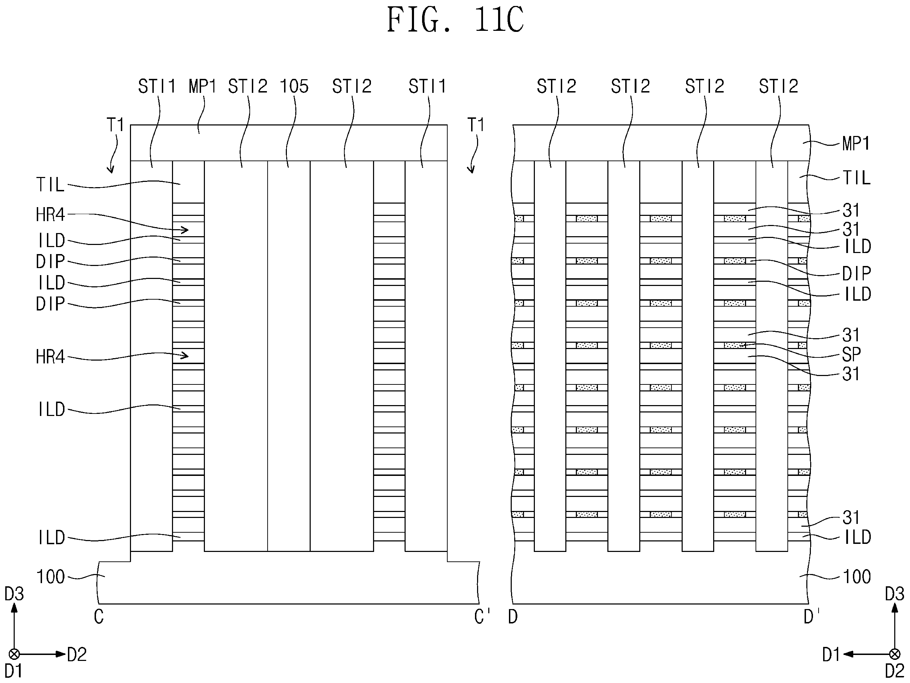

Referring to FIGS. 11A, 11B and 11C, a first mask pattern MP1 at least partially exposing the first sacrificial line patterns 103 may be formed on the upper insulating layer TIL.

The first trenches T1 at least partially exposing the semiconductor substrate 100 may be formed by etching the first sacrificial line patterns 103 by using the first mask pattern MP1 as an etching mask. In this case, the first trenches T1 may expose sidewalls of the channel patterns SP, sidewalls of the second sacrificial layers 30 and sidewalls of the interlayer insulating patterns ILD.

Fourth horizontal regions HR4 may be respectively formed between the channel patterns SP and the interlayer insulating patterns ILD by isotropically etching some portions of the second sacrificial layers 30 exposed to the first trenches T1.

The fourth horizontal regions HR4 may be formed by isotropically etching the second sacrificial layers 30 by using an etching recipe having etch selectivity with respect to the channel patterns SP and the interlayer insulating patterns ILD. For example, when the second sacrificial layers 30 are silicon nitride layers, and the interlayer insulating patterns ILD are silicon oxide layers, the fourth horizontal regions HR4 may be formed by isotropically etching the second sacrificial layers 30 by using etchant including a phosphoric acid. The fourth horizontal regions HR4 may extend between the first and second separation insulating patterns STI1 and STI2 in the first direction D1.

Since the fourth horizontal regions HR4 are formed, some portions of the second sacrificial layers 30 may be left to form the sacrificial patterns 31. The sacrificial patterns 31 may be separated from each other in the first direction D1 by the second separation insulating patterns STI2.

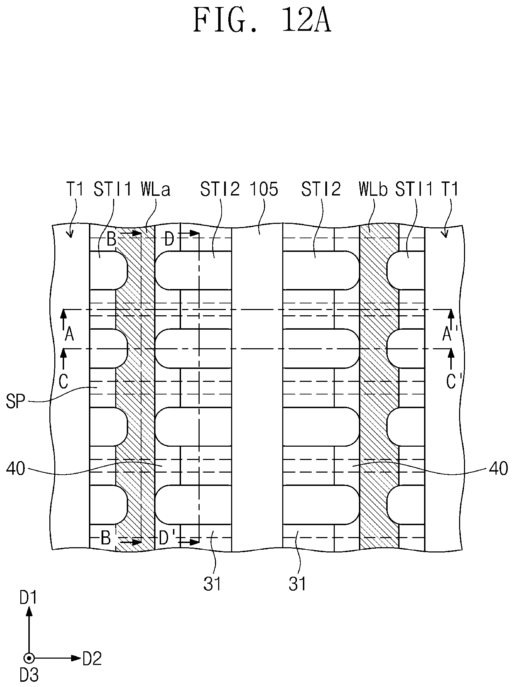

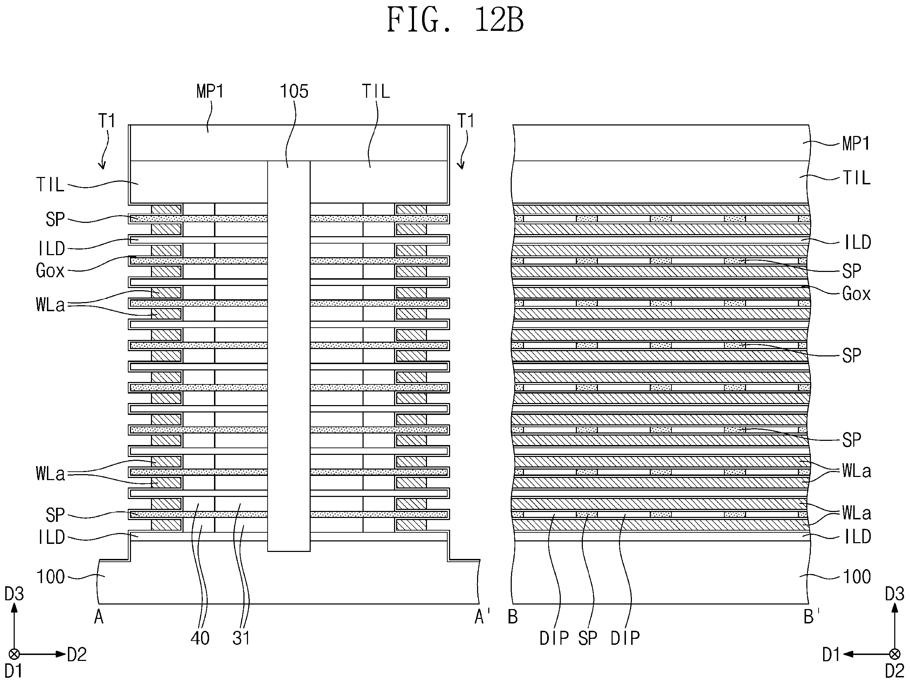

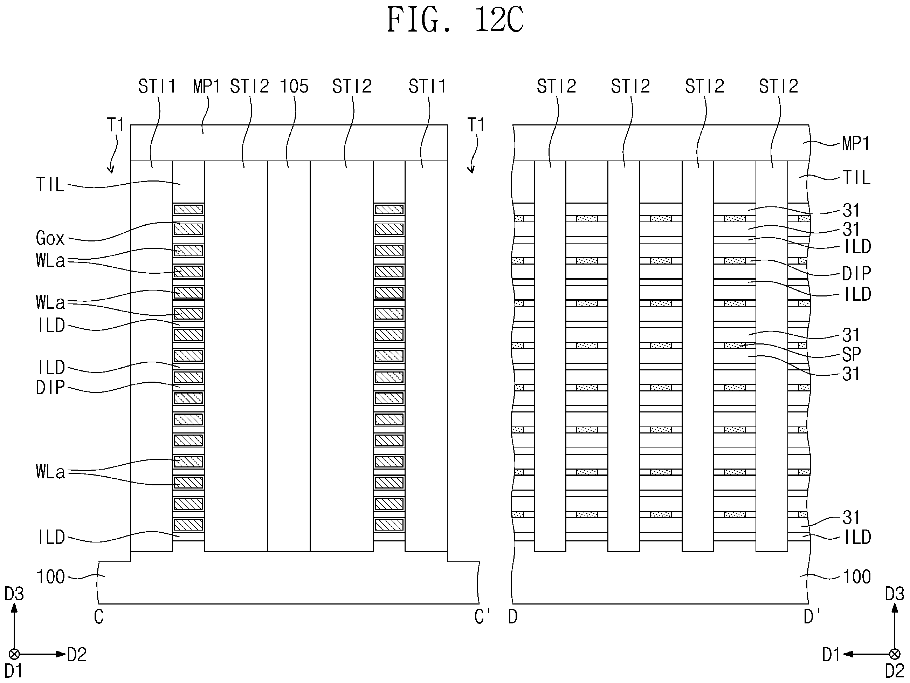

Referring to FIGS. 12A, 12B and 12C, second spacer insulating patterns 40 with which some portions of the fourth horizontal regions HR4 are at least partially filled may be formed.

The second spacer insulating patterns 40 may be formed by depositing an insulating layer to at least partially fill the fourth horizontal regions HR4, and then etching some portions of the insulating layer to leave the other portions of the insulating layer. The second spacer insulating patterns 40 may be separated from each other in the first direction D1 by the second separation insulating patterns STI2. The second spacer insulating patterns 40 may be formed of a material having etch selectivity with respect to the sacrificial patterns 31. For example, the second spacer insulating patterns 40 may include silicon oxide.

A gate insulating layer Gox and word lines WLa and WLb may be sequentially formed in the fourth horizontal regions HR4 in which the second spacer insulating patterns 40 are formed.

Forming the gate insulating layer Gox and the word lines WLa and WLb may include forming the gate insulating layer Gox conformally covering the fourth horizontal regions HR4 in which the second spacer insulating patterns 40 are formed, forming a gate conductive layer that at least partially fills the fourth horizontal regions HR4 on the gate insulating layer Gox, and forming the word lines WLa and WLb vertically (D3 direction) separated from each other by removing the gate conductive layer in the first trenches T1. In this case, sidewalls of the word lines WLa and WLb may be recessed more than sidewalls of the channel patterns SP, and some portions of the fourth horizontal regions HR4 may be at least partially filled with the word lines WLa and WLb. The word lines WLa and WLb may be formed on an upper surface and a lower surface of central portions (that is, channel portions) of the channel patterns SP, and may extend along the first direction D1. In other words, each word line WLa and WLb may have a double gate structure provided on an upper surface and a lower surface of the channel pattern SP. In other embodiments, the word line WLa and WLb may have a structure (that is, a gate-all-around structure) in which the central portions (that is, the channel portions) of the channel patterns SP are completely surrounded in a cross-sectional view.

The word lines WLa and WLb may have substantially the same profile as sidewalls of the first separation insulating patterns STI1 in portions adjacent to the sidewalls of the first separation insulating patterns STI1. That is, each of the word lines WLa and WLb may have a non-uniform width in the second direction D2.

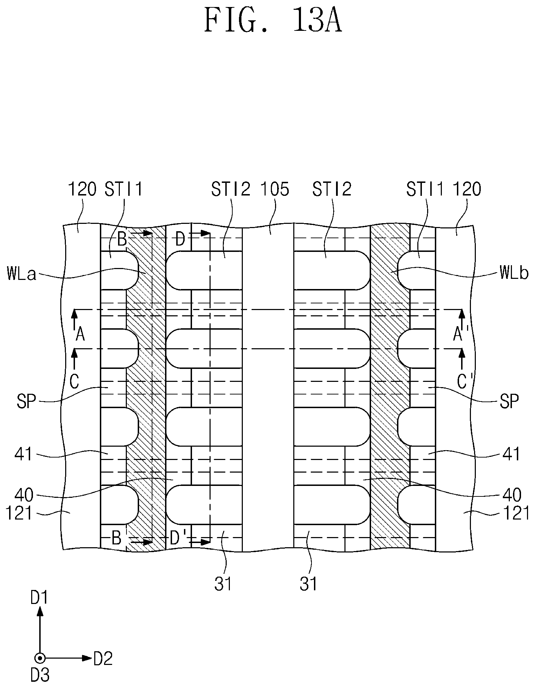

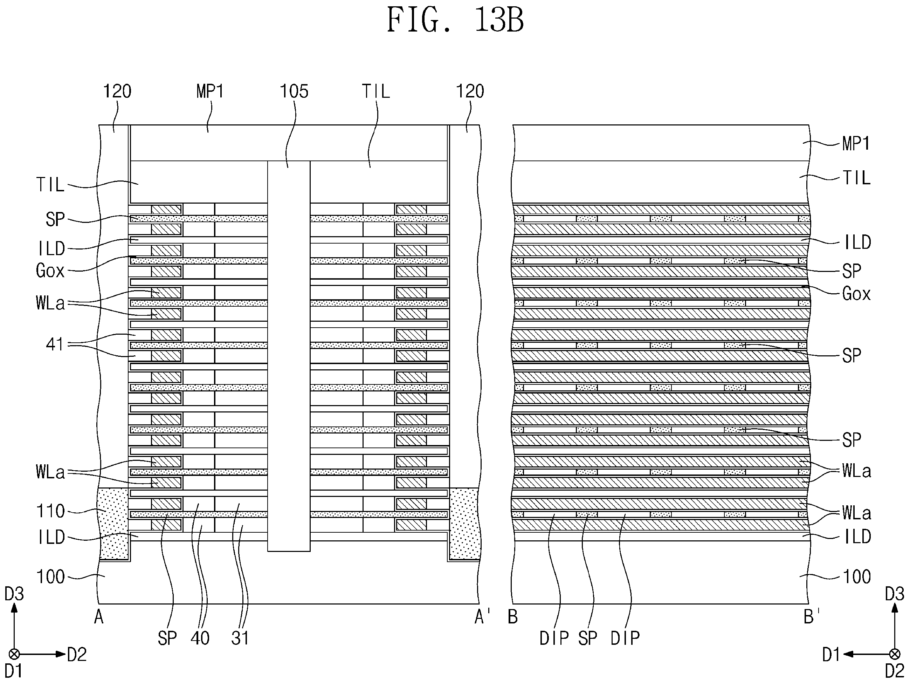

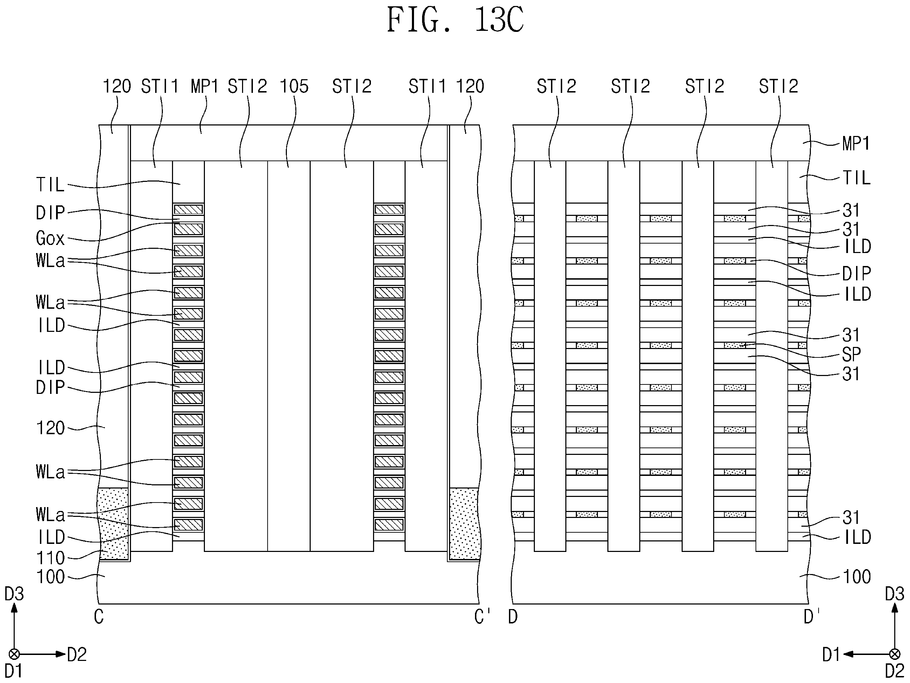

Referring to FIGS. 13A, 13B and 13C, first spacer insulating patterns 41 may be formed in the fourth horizontal regions HR4 in which the word lines WL are formed. The first spacer insulating patterns 41 may at least partially expose some of the channel patterns SP.

Forming the first spacer insulating patterns 41 may include forming a capping insulating layer on inner walls of the first trenches T1 to at least partially fill the fourth horizontal regions HR4, and removing the capping insulating layer with which the first trenches T1 are filled to at least partially expose sidewalls of the interlayer insulating patterns ILD. The capping insulating layer may be etched by performing an isotropic etching process having etch selectivity with respect to the interlayer insulating patterns ILD and the channel patterns SP. When the first spacer insulating patterns 41 are formed, the gate insulating layer Gox on the sidewalls of the interlayer insulating patterns ILD may be partially etched.

Before or after the first spacer insulating patterns 41 are formed, some portions of the channel patterns SP exposed to the first trenches T1 may be doped with impurities. Accordingly, the first dopant regions SD1 (see FIG. 1B) may be formed in the channel patterns SP. The first dopant regions SD1 may be formed through the first trenches T1 by performing a gas phase doping (GPD) process or a plasma-assisted doping (PLAD) process.

After the first spacer insulating patterns 41 are formed, a lower separation insulating layer 110 and an upper separation insulating layer 120 may be formed in the first trenches T1. The lower separation insulating layer 110 and the upper separation insulating layer 120 may extend along the first direction D1.

The lower separation insulating layer 110 may be formed by using a spin-coating method. When an insulating material having a low viscosity is spin-coated to form the lower separation insulating layer 110, the insulating material has excellent flowability so that lower portions of the first trenches T1 having a desired aspect ratio may be first at least partially filled with the insulating material.

According to some embodiments, the lower separation insulating layer 110 may be comprise an insulating material including carbon. The lower separation insulating layer 110 may be formed of an insulating material having a lower dielectric constant than a silicon oxide layer.

The lower separation insulating layer 110 may have etch selectivity with respect to the semiconductor substrate 100, the channel patterns SP, the interlayer insulating patterns ILD and the upper separation insulating layer 120.

For example, the lower separation insulating layer 110 may be formed of a fluorine-doped oxide (FSG) layer, a carbon-doped oxide layer, a silicon oxide layer, hydrogen silsesquioxane (HSQ; SiO:H), methyl silsesquioxane (MSQ; SiO:CH3), and/or a-SiOC (SiOC:H), or the like. For example, the lower separation insulating layer 110 may be formed by spin-coating SiOC (e.g. having a low viscosity).

The lower separation insulating layer 110 formed in the spin-coating process may be on and at least partially cover a sidewall of at least one channel pattern SP stacked from the top surface of the semiconductor substrate 100. For example, the lower separation insulating layer 110 may have a thickness range of about 1 Å to about 1000 Å.

After the lower separation insulating layer 110 is formed by spin-coating an insulating material including carbon, an oxygen (O2) plasma treatment process may also be performed. Accordingly, a content of carbon may be reduced in the insulating material. The content of carbon may be controlled in the lower separation insulating layer 110 by controlling a plasma treatment cycle during the oxygen plasma treatment process. For example, the content of carbon may be about 5% to about 60% in the lower separation insulating layer 110. Because the content of carbon decreases in the lower separation insulating layer 110, a wet etch-rate may increase, and a thickness of the lower separation insulating layer 110 may be controlled by using the wet etch-rate.

The upper separation insulating layer 120 may be formed by depositing an insulating material in the first trenches T1 in which the lower separation insulating layer 110 is formed. The upper separation insulating layer 120 may be formed by using atomic layer deposition (ALD) or chemical vapor deposition (CVD). The upper separation insulating layer 120 may be formed of an insulating material having etch selectivity with respect to the lower separation insulating layer 110, and the insulating material may be, for example, one among a silicon oxide layer, a silicon nitride layer, and/or a silicon oxynitride layer. The upper separation insulating layer 120 formed by using a deposition process may include a seam or void thereinside.

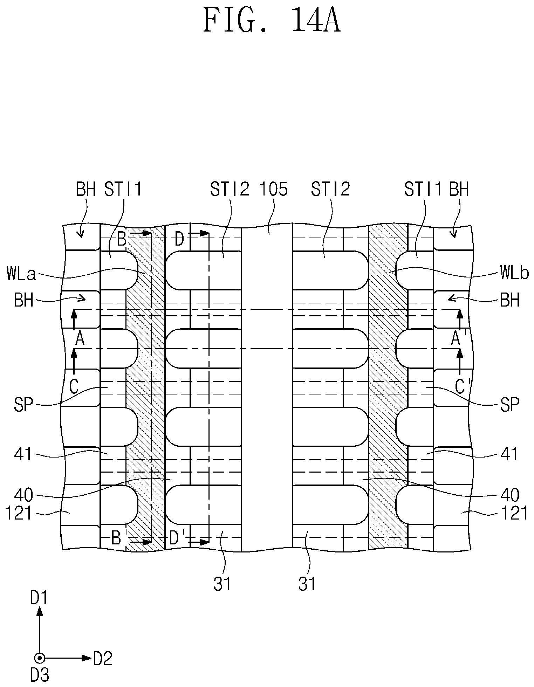

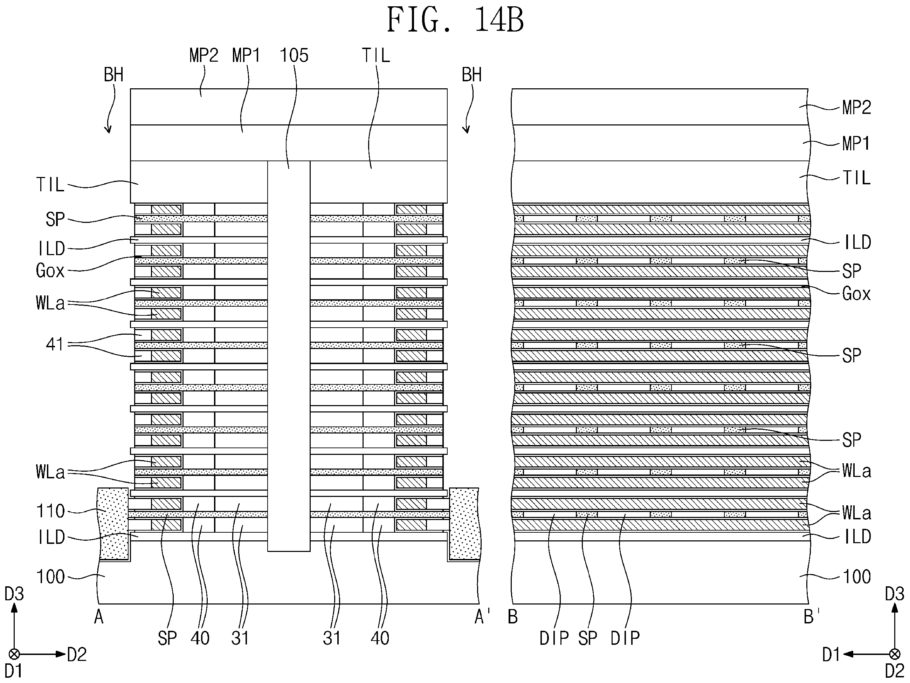

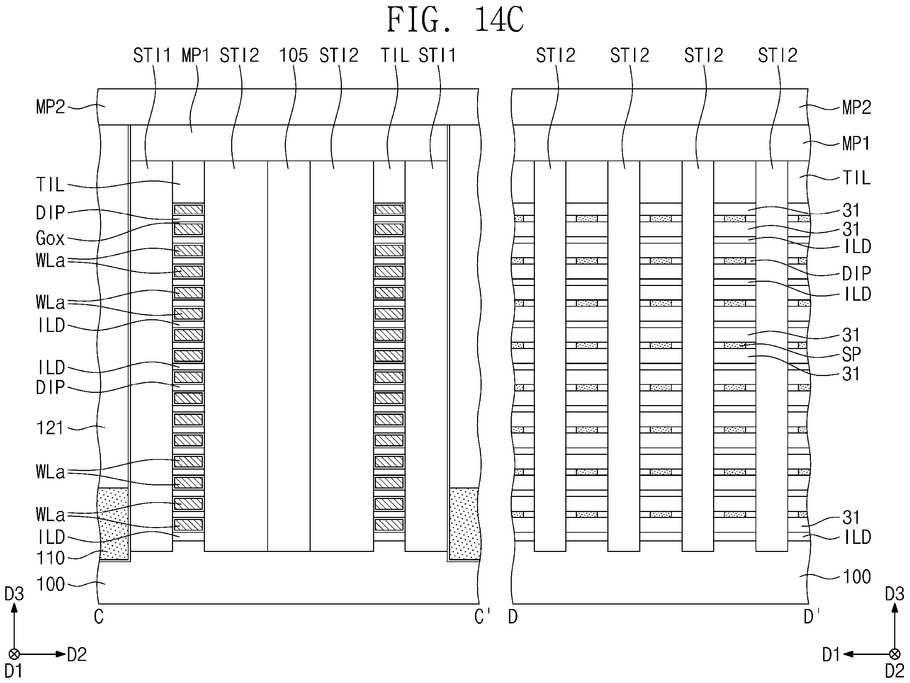

Referring to FIGS. 14A, 14B and 14C, vertical holes BH vertically (D3 direction) penetrating or extending through the upper separation insulating layer 120 and at least partially exposing the lower separation insulating layer 110 may be formed. The vertical holes BH may be spaced apart from each other in the first direction D1, and may at least partially expose the sidewalls of the channel patterns SP.

Forming the vertical holes BH may include forming a second mask pattern MP2 having openings respectively corresponding to the vertical holes BH on the first mask pattern MP1 and the upper separation insulating layer 120, and anisotropically etching the upper separation insulating layer 120 by using the second mask pattern MP2 as an etching mask. In addition, when the vertical holes BH are formed, an anisotropic etching process and an isotropic etching process may be sequentially performed. Specifically, preliminary vertical holes at least partially exposing the lower separation insulating layer 110 may be formed by performing the anisotropic etching process of the upper separation insulating layer 120, and the sidewalls of the channel patterns SP may be exposed to the vertical holes BH by supplying etchant through the preliminary vertical holes to isotropically etch the upper separation insulating layer 120.

When the vertical holes BH are formed, the lower separation insulating layer 110 may be used as an etch stop layer. Since the isotropic etching process is performed during formation of the vertical holes BH, first spacer insulating patterns 41 may be recessed, and thus a portion of a lower surface and a portion of an upper surface of each channel pattern may be at least partially exposed. In addition, or alternatively, a portion of a lower surface and a portion of an upper surface of each interlayer insulating pattern ILD may be at least partially exposed.

Upper separation insulating patterns 121 may be formed by partially etching the upper separation insulating layer 120 during the formation of the vertical holes BH. The upper separation insulating patterns 121 may be respectively in contact with the first separation insulating patterns STI1.

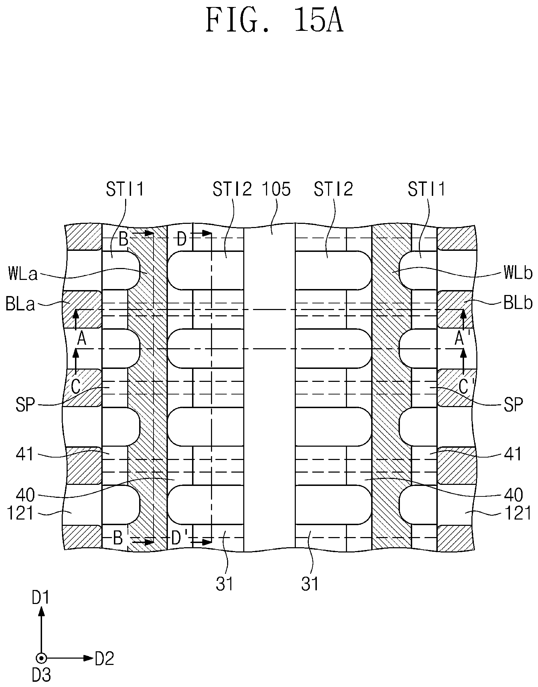

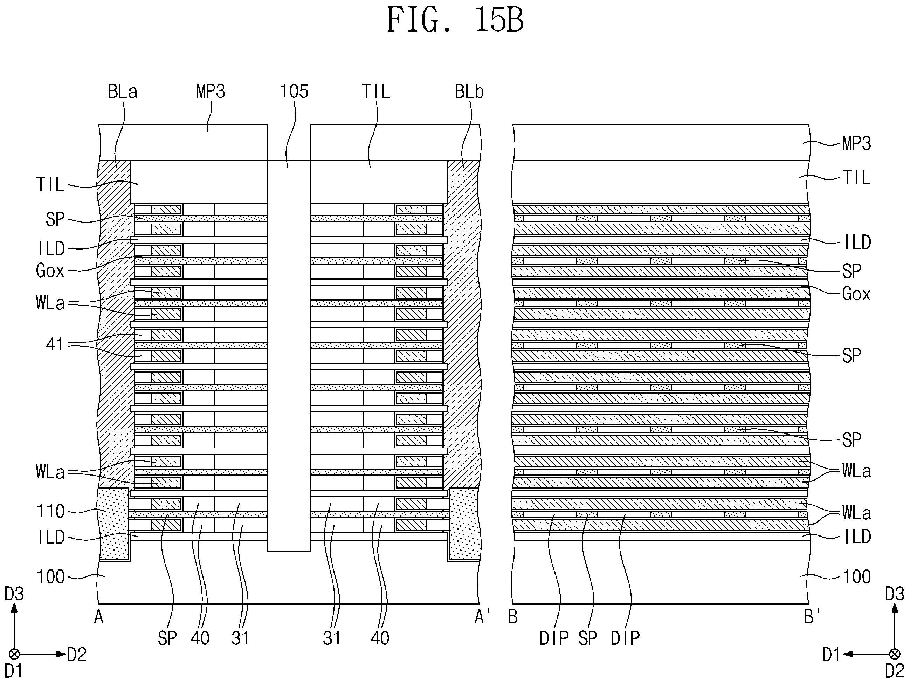

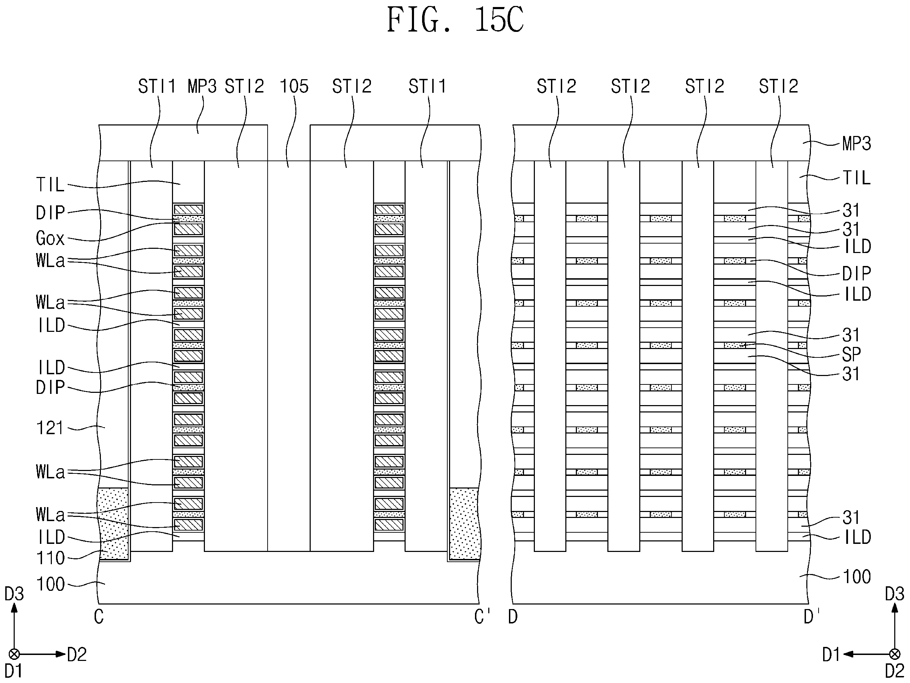

Referring to FIGS. 15A, 15B and 15C, bit lines BLa and BLb may be formed in the vertical holes BH. The first and second mask patterns may be removed before or after the bit lines are formed.

Forming the bit lines BLa and BLb may include depositing a conductive layer to at least partially fill the vertical holes BH, and exposing the upper separation insulating layer by performing a process of planarizing the conductive layer. Accordingly, the bit lines BLa and BLb may be separated from each other in the first direction D1 by the upper separation insulating patterns 121, and each of the bit lines BLa and BLb may be in contact with the first dopant regions SD1 of the channel patterns SP. The each of the bit lines BLa and BLb may include at least one of impurity-doped silicon, a metal material, a metal nitride layer or a metal silicide. For example, the bit lines BLa and BLb may include doped polysilicon, a tantalum nitride layer, and/or tungsten.

After the bit lines BLa and BLb are formed, a third mask pattern MP3 on and at least partially covering the bit lines BLa and BLb, the upper separation patterns 121 and the upper insulating layer TIL may be formed. The third mask pattern MP3 may have an opening at least partially exposing the second sacrificial line pattern 105.

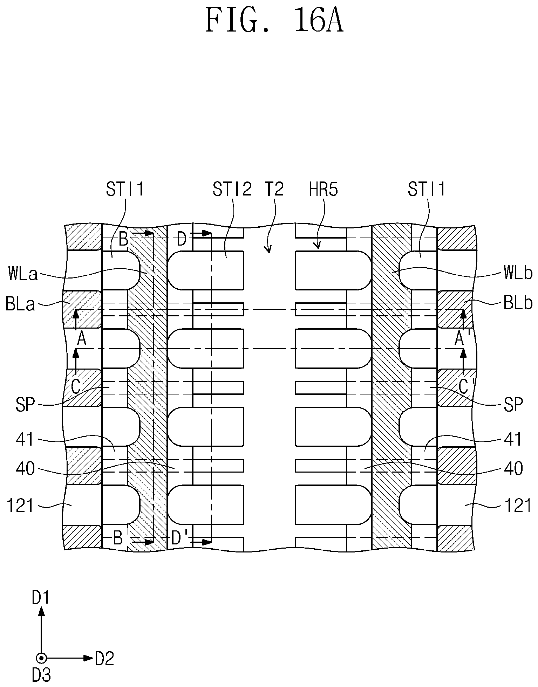

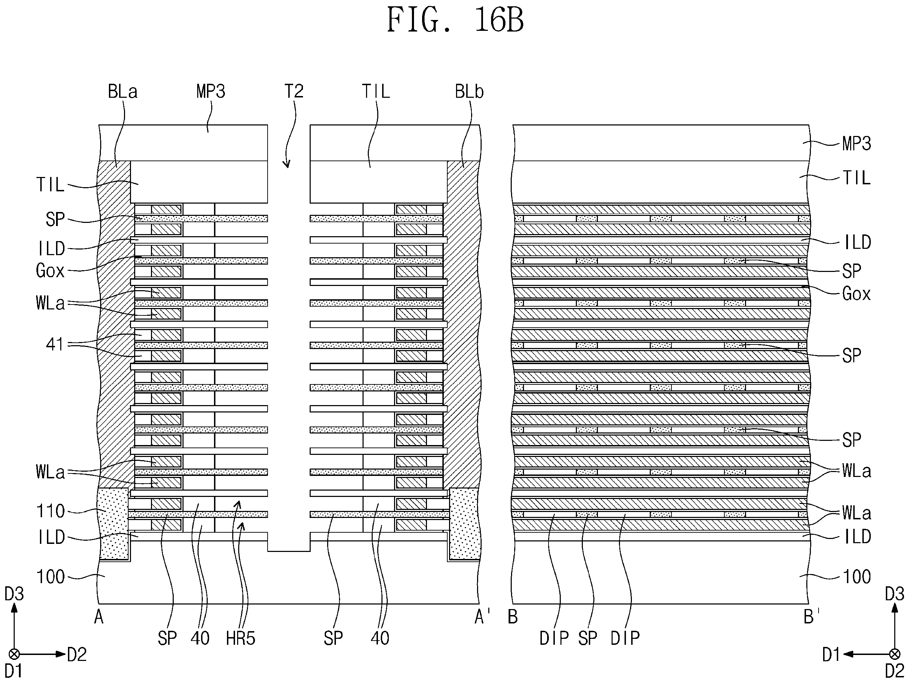

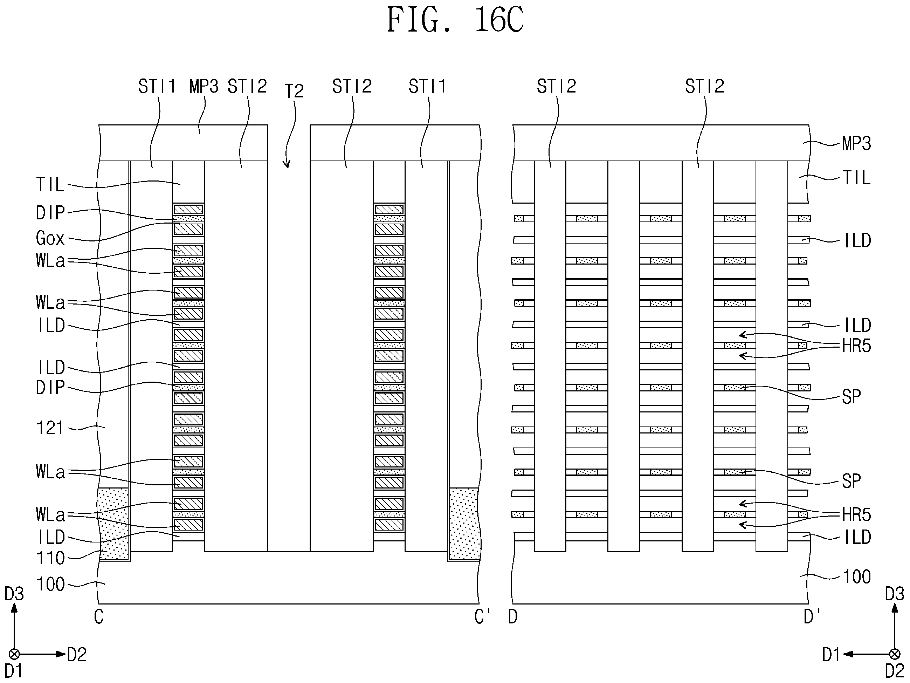

Referring to FIGS. 16A, 16B and 16C, the second trench T2 may be reformed by removing the second sacrificial line pattern 105 at least partially exposed by the third mask pattern MP3. In this case, sidewalls of the sacrificial patterns 31, sidewalls of the channel patterns SP, and sidewalls of the interlayer insulating patterns ILD may be exposed to the second trenches T2.

Thereafter, fifth horizontal regions HR5 at least partially exposing the second spacer insulating patterns 40 may be formed by removing the sacrificial patterns 31 exposed to the second trenches T2.

Forming the fifth horizontal regions HR5 may include isotropically etching the sacrificial patterns 31 by performing an etching process having etch selectivity with respect to the semiconductor substrate 100, the channel patterns SP and the interlayer insulating patterns ILD. When the sacrificial patterns 31 are isotropically etched, the second spacer insulating patterns 40 may be used as an etch stop layer.

The fifth horizontal regions HR5 may be respectively formed vertically (D3 direction) between the interlayer insulating patterns ILD and the channel patterns SP, and horizontally between the second separation insulating patterns STI2.

A length in the second direction D2 of the channel patterns SP may be reduced by partially etching the channel patterns SP exposed to the fifth horizontal regions HR5. That is, after the fifth horizontal regions HR5 are formed, the channel patterns SP may be partially isotropically etched. Accordingly, one sidewall of the channel patterns SP may be aligned with one sidewall of the second spacer insulating patterns 40.

The channel patterns SP exposed to the fifth horizontal regions HR5 may be partially doped with a first conductive dopant (for example, phosphorous or boron). Accordingly, the second dopant regions SD2 (see FIG. 1B) may be formed in the channel patterns SP.

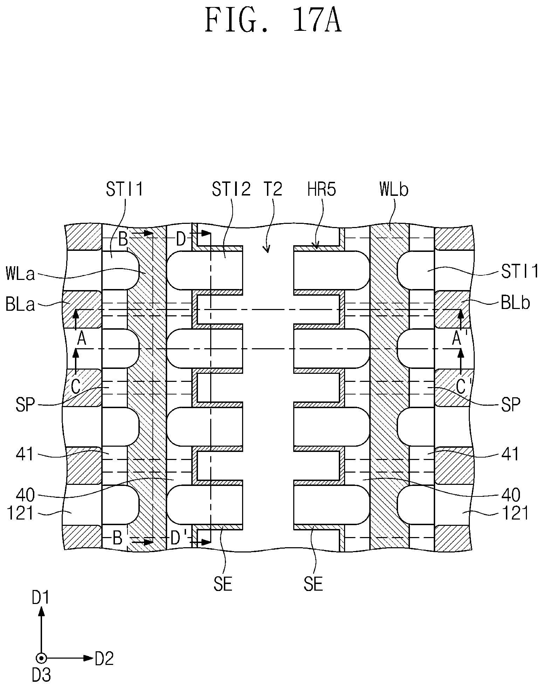

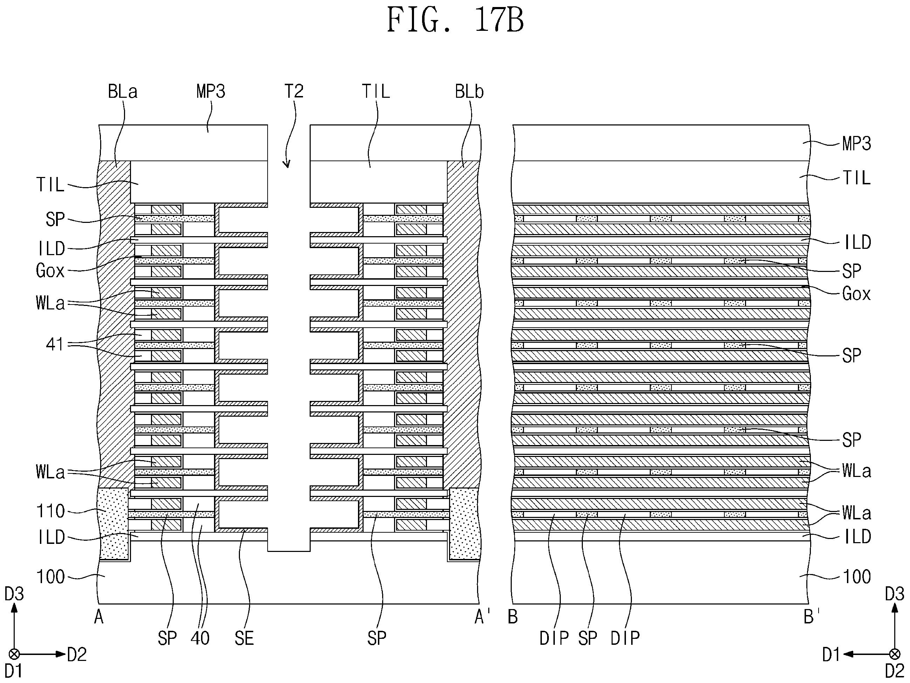

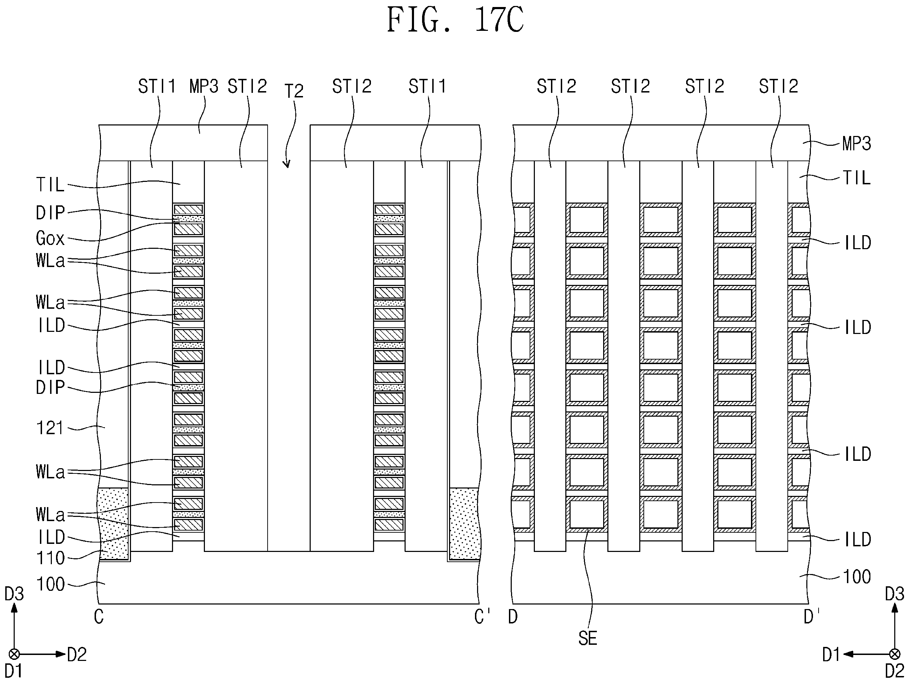

Referring to FIGS. 17A, 17B and 17C, storage electrodes SE may be locally formed in the fifth horizontal regions HR5.

Forming the storage electrodes SE may include depositing a conductive layer conformally at least partially covering inner walls of the fifth horizontal regions HR5 and inner walls of the second trenches T2, and partially removing the conductive layer deposited on the inner walls of the second trenches T2 to locally leave conductive patterns in the fifth horizontal regions HR5.

The storage electrodes SE may be spaced apart from each other in the first direction D1, the second direction D2 and the third direction D3. The storage electrodes SE may be in contact with the channel patterns SP exposed to the fifth horizontal regions HR5. Each of the storage electrodes SE may define an empty space in the fifth horizontal regions HR5. In other words, each of the storage electrodes SE may have a shape of a cylinder (or cup shape) having a long axis in the second direction D2, and having an empty inner space. In other embodiments, the storage electrode SE may have a shape of a pillar having a long axis in the second direction D2. In these embodiments, the pilar shape may be received into a corresponding recess within the plate electrode PE (the pillar shape being surrounded by the capacitor dielectric layer CIL). The storage electrode SE may include at least one of a metal material, a metal nitride layer, and/or metal silicide.

Thereafter, as illustrated in FIGS. 1A, 1B and 1C, a capacitor dielectric layer CIL conformally at least partially covering the fifth horizontal regions HR5 in which the storage electrodes SE are formed, and a plate electrode PE with which the fifth horizontal regions HR5 and the second trenches T2 in which the storage electrodes SE and the capacitor dielectric layer CIL are formed may be formed.

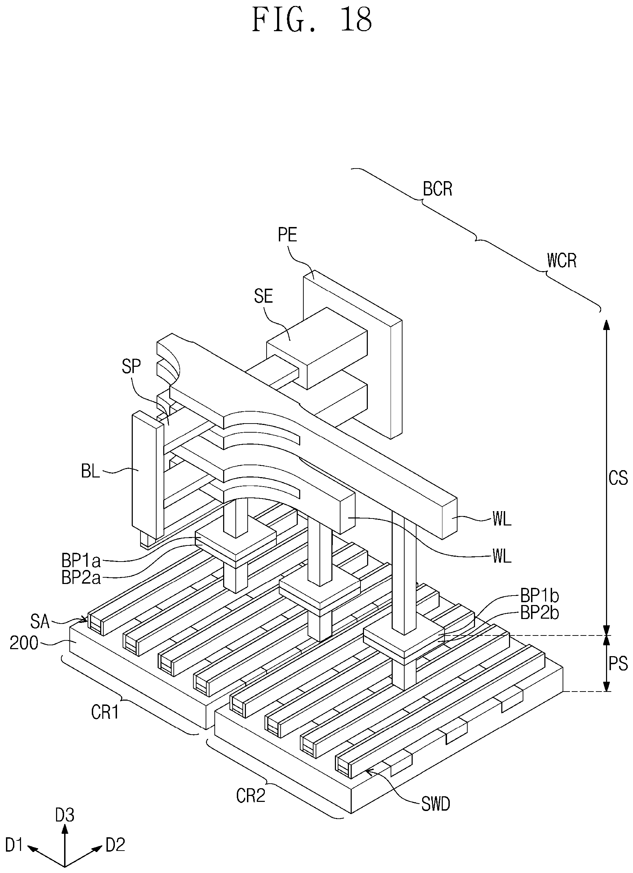

FIG. 18 is a perspective view illustrating a semiconductor memory device according to embodiments of the inventive concept. Certain layers are removed from the view to aid in understanding.

Referring to FIG. 18, a semiconductor memory device may include a cell array structure CS and a peripheral circuit structure PS on the cell array structure CS.

According to some embodiments, the semiconductor memory device may have a chip-to-chip (C2C) structure. The C2C structure may mean a structure in which an upper chip including the cell array structure CS is manufactured on a first wafer, a lower chip including the peripheral circuit structure PS is manufactured on a second wafer different from the first wafer, and the upper chip and the lower chip are connected to each other in a bonding manner. For example, the bonding manner may mean a manner in which bonding metal formed on an uppermost metal layer of the upper chip and bonding metal formed on an uppermost metal layer of the lower chip are electrically connected to each other. For example, when the bonding metal is formed of copper (Cu), the bonding manner may be a Cu-to-Cu bonding manner, and the bonding metal may be formed of aluminum (Al) or tungsten (W).

The cell array structure CS may include word lines WL, bit lines BL and first bonding pads BP1a and BP1b.

The cell array structure CS may include a first region BCR (or a bit line connection region) and a second region WCR (or a word line connection region).

The word lines WL may extend in the first direction D1, and may be vertically stacked along the third direction D3. The word lines WL may extend from the first region BCR to the second region WCR, and the bit lines BL may be provided to the first region BCR. The word lines WL may include pad portions connected to a cell contact plug in the second region WCR. The word lines WL may be stacked having a step structure in the second region WCR. The pad portions of the word line WL may be located at positions horizontally (D1 and D2 directions) and vertically (D3 direction) different from each other.

According to some embodiments, each of the word lines WL may have a double gate structure crossing both surfaces of the channel pattern SP. In other embodiments, each of the word lines WL may have a structure (that is, a gate-all-around structure) completely surrounding the channel pattern SP in a cross-sectional view.

The bit lines BL may extend in the third direction D3, and may be connected to the channel patterns SP stacked in the third direction D3.

A first end portion of the channel pattern SP may be connected to the bit line BL, and a second end portion of the channel pattern SP may be connected to a storage electrode SE. According to embodiments of the inventive concept, the first bonding pads BP1a and BP1b of the cell array structure CS may include first upper bonding pads BP1a provided to the first region BCR, and second upper bonding pads BP1b provided to the word line connection regions WCR.

The first upper bonding pads BP1a may be electrically connected to the bit lines BL through conductive lines and contact plugs, and the second upper bonding pads BP1b may be connected to the pad portions of the word lines WL through the conductive lines and cell contact plugs.

The peripheral circuit structure PS may include a semiconductor substrate 200, sense amplifiers SA on the semiconductor substrate 200, sub-word line drivers SWD, peripheral circuits PTR and second bonding pads BP2a and BP2b.

Specifically, the semiconductor substrate 200 of the peripheral circuit structure PS may include a first core region CR1 and a second core region CR2. The first and second core regions CR1 and CR2 may vertically (D3 direction) overlap a memory cell array region CAR.

A plurality of sense amplifiers SA may be provided onto the semiconductor substrate 200 of the first core region CR1. A plurality of sub-word line drivers SWD may be provided onto the semiconductor substrate 200 of the second core region CR2.

The second bonding pads BP2a and BP2b of the peripheral circuit structure PS may include first lower bonding pads BP2a provided to the first core region CR1, and second lower bonding pads BP2b provided to the second core region CR2.

The first lower bonding pads BP2a may be electrically connected to the sense amplifiers SA through conductive lines and contact plugs. The second lower bonding pads BP2b may be electrically connected to the sub-word line drivers SWD through the conductive lines and the contact plugs.

According to some embodiments, the first and second lower bonding pads BP2a and BP2b may be respectively directly connected to the first and second upper bonding pads BP1a and BP1b. The first and second lower and upper bonding pads BP1a, BP1b, BP2a and BP2b may include the same metal material, and may have the substantially same size or area. For example, the first and second lower and upper bonding pads BP1a, BP1b, BP2a and BP2b may include copper (Cu), aluminum (Al), nickel (Ni), cobalt (Co), tungsten (W), titanium (Ti), and/or tin (Sn), or an alloy thereof.

According to some embodiments of the inventive concept, leakage current may be reduced or prevented from occurring between bit lines and a semiconductor substrate by disposing a lower separation insulating layer between the bit lines and the semiconductor substrate on a first side of a stack structure.

In addition, because the lower separation insulating layer is formed of an insulating material including carbon or a material having a lower dielectric constant than upper separation insulating patterns that insulate the bit lines adjacent to each other, a seam or void may be prevented from being formed in the lower separation insulating layer. Accordingly, the bit lines having a uniform shape may be formed on the lower separation insulating layer.

In a comparative example, where the lower separation insulating patterns are not provided, the bit lines may be instead insulated from each other and from the semiconductor substrate by a bottom isolation region. The bottom isolation region may be formed of silicon dioxide (SiO₂). The bottom isolation region may be formed through atomic layer deposition. The bottom isolation region may be formed to fill the trench, before being etched and filled with bit lines. However, voids and seams may be formed within the bottom isolation region due to characteristics of the atomic layer deposition process (e.g. for SiO₂) affected by a profile of a lower region of the trench. Accordingly, since the voids are exposed during partial dry etching and wet cleaning, position distribution may increase, and thus it is difficult to set an etching target.

According to embodiments, firstly, a lower separation insulating layer having wet etching selectivity may be formed (e.g. of SiOC) on the bottom of the trench by spin-coating. The material of the lower separation insulating layer may have a low viscosity. The remainder of the trench may then be filled with the upper separation insulating layer (e.g. via atomic layer deposition of SiO₂), and portions of the upper separation insulating layer may be removed performing partial dry etching and wet etching, to form the bottom isolation region and the upper separation insulating pattern.

Given the above, the embodiments described herein allow the bit lines to be manufactured more accurately.

Embodiments are set out in the following Clauses:
Clause 1. A semiconductor memory device comprising:
   a stack structure including word lines and interlayer insulating patterns alternately stacked on a semiconductor substrate, the word lines extending in a first direction parallel to a top surface of the semiconductor substrate;
   channel patterns intersecting the word lines and having a long axis in a second direction parallel to the top surface of the semiconductor substrate, the channel patterns spaced apart from each other on the semiconductor substrate in the first direction and in a third direction perpendicular to the top surface of the semiconductor substrate;
   a lower separation insulating layer on the semiconductor substrate on a first side of the stack structure;
   bit lines spaced apart from each other on the lower separation insulating layer in the first direction, each of the bit lines connected to first end portions of the channel patterns, which are spaced apart from each other in the third direction; and
   upper separation insulating patterns between the bit lines, respectively, and adjacent to each other in the first direction,
   wherein the lower separation insulating layer includes an insulating material having a lower dielectric constant than that of the upper separation insulating patterns.
Clause 2. The semiconductor memory device of Clause 1, wherein the lower separation insulating layer comprises an insulating material including carbon.
Clause 3. The semiconductor memory device of Clause 1 or Clause 2, wherein the lower separation insulating layer is on a sidewall of at least one or more of the channel patterns adjacent to the semiconductor substrate.
Clause 4. The semiconductor memory device of any of Clauses 1-3, wherein the lower separation insulating layer has a rounded upper surface.
Clause 5. A semiconductor memory device comprising:
   a stack structure including word lines and interlayer insulating patterns alternately stacked on a semiconductor substrate, the word lines extending in a first direction parallel to a top surface of the semiconductor substrate;
   channel patterns intersecting the word lines and having a long axis in a second direction parallel to the top surface of the semiconductor substrate, the channel patterns spaced apart from each other on the semiconductor substrate in the first direction and in a third direction perpendicular to the top surface of the semiconductor substrate;
   a lower separation insulating layer on the semiconductor substrate on a first side of the stack structure;
   bit lines spaced apart from each other in the first direction on the lower separation insulating layer, each of the bit lines connected to first end portions of the channel patterns, which are spaced apart from each other in the third direction;
   upper separation insulating patterns between the bit lines, respectively, and adjacent to each other in the first direction;
   first separation insulating patterns between the first end portions of the channel patterns, respectively, and spaced apart from each other in the first direction;
   second separation insulating patterns between second end portions opposite to the first end portions of the channel patterns, respectively, and spaced apart from each other in the first direction; and
   data storage elements between the interlayer insulating patterns, respectively, adjacent to each other in the third direction, and connected to the second end portions of the channel patterns.
Clause 6. The semiconductor memory device of Clause 5, wherein the lower separation insulating layer extends along the first direction, and
   wherein the upper separation insulating patterns are spaced apart from each other in the first direction.

Although the embodiments of the present invention have been described, it is understood that the present invention should not be limited to these embodiments but various changes and modifications can be made by one ordinary skilled in the art within the spirit of the present invention as hereinafter claimed.

## Claims

1. A semiconductor memory device comprising:
a stack structure (ST1) including word lines (WLa) and interlayer insulating patterns (ILD) alternately stacked on a semiconductor substrate (100), the word lines (WLa) extending in a first direction parallel to a top surface of the semiconductor substrate (100);
channel patterns (SP) intersecting the word lines (WLa) and having a long axis in a second direction parallel to the top surface of the semiconductor substrate (100), the channel patterns (100) being spaced apart from each other in the first direction and in a third direction perpendicular to the top surface of the semiconductor substrate (100);
a lower separation insulating layer (110) on the semiconductor substrate (100) at a first side of the stack structure (ST1); and
bit lines (BLa) spaced apart from each other on the lower separation insulating layer (110) in the first direction, each of the bit lines being connected to first end portions of the channel patterns (SP) which are spaced apart from each other in the third direction,
wherein the lower separation insulating layer (110) is on a first side surface of a lowermost channel pattern (SP) of the channel patterns (SP).

2. The semiconductor memory device of claim 1, wherein the lower separation insulating layer (110) extends in parallel to the stack structure (ST1) along the first direction.

3. The semiconductor memory device of claim 1 or claim 2, wherein the lower separation insulating layer (110) comprises an insulating material including carbon.

4. The semiconductor memory device of any preceding claim, wherein the lower separation insulating layer (110) has a rounded upper surface.

5. The semiconductor memory device of any preceding claim, wherein a bottom surface of the lower separation insulating layer (110) is closer to the substrate (100) than a lowermost interlayer insulating pattern (ILD) of the interlayer insulating patterns (ILD).

6. The semiconductor memory device of any preceding claim, wherein the lower separation insulating layer (110) is on sidewalls of at least two interlayer insulating patterns (ILD) adjacent to the semiconductor substrate (100).

7. The semiconductor memory device of any preceding claim, wherein the lower separation insulating layer (110) comprises an insulating material different from that of the interlayer insulating patterns (ILD).

8. The semiconductor memory device of any preceding claim, further comprising upper separation insulating patterns (121) between the bit lines adjacent to each other in the first direction, respectively, on the lower separation insulating layer (110).

9. The semiconductor memory device of claim 8, wherein the upper separation insulating patterns (121) comprise an insulating material different from the lower separation insulating layer (110).

10. The semiconductor memory device of any preceding claim, further comprising:
first separation insulating patterns (STI1) between the first end portions of the channel patterns (SP), respectively, and spaced apart from each other in the first direction; and
second separation insulating patterns (STI2) between second end portions opposite to the first end portions of the channel patterns (SP), respectively, and spaced apart from each other in the first direction,
wherein the first and second separation insulating patterns (STI1, STI2) extend in the third direction to extend through the stack structure (ST1).

11. The semiconductor memory device of claim 10, wherein a bottom surface of the lower separation insulating layer (110) is closer to the substrate than bottom surfaces of the first separation insulating patterns (STI1).

12. The semiconductor memory device of any preceding claim, further comprising data storage elements (DS) between the interlayer insulating patterns (ILD), respectively, and adjacent to each other in the third direction, the data storage elements (DS) contacting second end portions opposite to the first end portions of the channel patterns (SP).

13. The semiconductor memory device of claim 12, further comprising:
first spacer insulating patterns (41) on the first end portions of the channel patterns (SP) between the bit lines (BLa) and the word lines (WLa); and
second spacer insulating patterns (40) on the second end portions of the channel patterns (SP) between the data storage elements (DS) and the word lines (WLa).

14. The semiconductor memory device of claim 12 or claim 13, wherein the data storage elements (DS) comprise:
storage electrodes (SE) contacting the second side surfaces of the channel patterns (SP), and being parallel to an upper surface of the semiconductor substrate (100);
a dielectric layer (CIL) conformally at least partially covering the storage electrodes (SE); and
a plate electrode (PE) on the dielectric layer (CIL).

15. A semiconductor memory device comprising:
a stack structure (ST1) including word lines (WLa) and interlayer insulating patterns (ILD) alternately stacked on a semiconductor substrate (100), the word lines (WLa) extending in a first direction parallel to a top surface of the semiconductor substrate (100);
channel patterns (SP) intersecting the word lines (WLa) and having a long axis in a second direction parallel to the top surface of the semiconductor substrate (100), the channel patterns (SP) being spaced apart from each other on the semiconductor substrate (100) in the first direction and in a third direction perpendicular to the top surface of the semiconductor substrate (100);
a lower separation insulating layer (110) on the semiconductor substrate (100) on a first side of the stack structure (ST1);
bit lines (BLa) spaced apart from each other on the lower separation insulating layer (110) in the first direction, each of the bit lines (BLa) being connected to first end portions of the channel patterns (SP), which are spaced apart from each other in the third direction; and
upper separation insulating patterns (121) between the bit lines (BLa), respectively, and adjacent to each other in the first direction,
wherein the lower separation insulating layer (110) includes an insulating material having a lower dielectric constant than that of the upper separation insulating patterns (121).
